(19) Europäisches Patentamt
European Patent Office
Office européen des brevets

(11) EP 0 977 145 A2

(12) **EUROPEAN PATENT APPLICATION**

(43) Date of publication:
**02.02.2000 Bulletin 2000/05**

(51) Int Cl.⁷: **G06K 19/077**

(21) Application number: **99114633.3**

(22) Date of filing: **26.07.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.07.1998 JP 21296398**
**30.11.1998 JP 33893498**
**24.02.1999 JP 4639299**

(71) Applicant: **KABUSHIKI KAISHA TOSHIBA**
**Kawasaki-shi, Kanagawa-ken 210-8572 (JP)**

(72) Inventors:
- **Karasawa, Jun, c/o Kabushiki Kaisha Toshiba Tokyo 105-8001 (JP)**
- **Segawa, Masao, c/o Kabushiki Kaisha Toshiba Tokyo 105-8001 (JP)**
- **Saito, Yasuhito c/o Kabushiki Kaisha Toshiba Tokyo 105-8001 (JP)**

(74) Representative: **Henkel, Feiler, Hänzel**
**Möhlstrasse 37**
**81675 München (DE)**

(54) **Radio IC card**

(57) A first antenna coil (22) is formed on a surface of an IC chip (23). A second coil (31) and a third coil (32) are formed on a module board (30). The IC chip (23) is mounted on the module board (30) such that the first antenna coil (22) of the IC chip (23) is opposed to the second antenna coil (21).

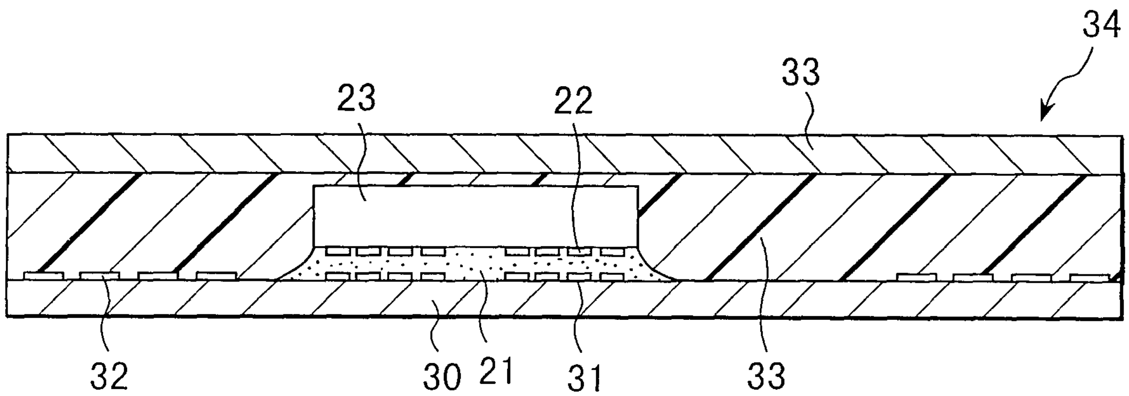


FIG. 14

EP 0 977 145 A2

## Description

The present invention relates to an improvement of a radio IC card wherein an IC (integrated circuit) is buried in a plastic card, etc., a method of manufacturing the radio IC card, a data read/write apparatus for the radio IC card, a radio tag and a method of manufacturing the radio tag.

There are known non-contact type data carrier modules such as a radio IC card and a radio tag. The data carrier module comprises an IC chip functioning as a semiconductor device and a wound antenna (hereinafter referred to as "antenna coil"). There are various types of data carrier modules having different structures. Depending on the type of the structure, the data carrier module may include a capacitor for synchronization or a capacitor for power supply.

The antenna coil functions both for data communication and for power supply from the outside. There are various types of antenna coils, for example, a winding coil, a coil formed on a board by means of etching, and a coil formed on a board by means of printed wiring. The number of turns of the antenna coil varies in accordance with the communication frequency, communication distance, etc.

With recent development in the reduction in size, data carrier modules have widely been used and there is a demand for techniques for mass-producing them at low cost.

Under the circumstances, research and development has been made for methods of mass-producing data carrier modules by physically and electrically connecting IC chips and antenna coils. In such methods, for example, semiconductor devices are directly mounted on boards by flip-chip bonding, or semiconductor devices are connected to module boards by wire bonding.

FIG. 1 shows a perspective view of a conventional radio IC card, and FIG. 2 is a cross-sectional view of the same.

A rectangular-spiral coil pattern 2 is formed on a wiring board 1. An IC chip 3 used as a semiconductor device is mounted on the wiring board 1. An electrode 4 of the IC chip 3 is electrically connected to an electrode 5 on the wiring board 1 by means of a gold ball bump 6.

A method of manufacturing the radio IC card will now be described.

The IC chip 3 is first mounted on the wiring board 1 by means of bonding.

Then a thermoplastic sheet 7 is provided on both sides of the wiring board 1 by thermal fusion.

The sheet 7 is formed of, e.g. vinyl chloride or PET (polyethylene terephthalate). The entirety of the wiring board 1 is resin-molded by the thermal fusion of sheet 7.

The thus formed radio IC card is, for example, about 0.2 to 0.7 mm thick.

FIG. 3 is an electric circuit diagram of this radio IC card. The IC chip 3 is connected to the coil pattern 2. The IC chip 3 has functions of data control, data storage, etc. The IC chip 3 performs data transmission between itself and the outside and receives power through the coil pattern 2.

However, in the above method, when the IC chip 3 and coil pattern 2 are physically and electrically connected, the IC chip 3 is mounted on the wiring board 1. This method requires expensive equipment such as a flip-chip bonder or a wire-bonder.

In the order of the manufacturing steps, the step of mounting the IC chip 3 must precede the others. Thus there are many restrictions on the manufacturing steps, and the manufacturing steps are complicated.

In addition, in the case of the resin-molding, a process management, for example, for considering heat-resistance, is needed and the reliability lowers.

FIG. 4 is a structure of another radio IC card.

An IC chip 2 and a communication antenna 9 connected to the IC chip 2 are mounted on a card body 8, and a button cell 10 is built in.

FIG. 5 is a structure of another radio IC card and FIG. 6 is a cross-sectional view of the IC card.

An IC chip 2, a communication antenna 9 connected to the IC chip 2, and a power supply coil 10 are mounted on the card body 8.

In order to ensure security and reliability, the radio IC card is formed in a shape which does not permit easy dissembling, for example, by mold-sealing or thermal-pressing.

In the case of the radio IC card including the cell, however, the life of the radio IC card is limited by the life of the cell and this is very economically disadvantageous.

There is also known an electromagnetic-induction-type radio IC card to which power is supplied from a radio IC card reader in the form of electromagnetic waves. In the case of this IC card, the reader needs to constantly send signals. This is not preferable from the standpoint of energy saving.

For example, in a gate entrance/exit system, incoming/outgoing persons with radio IC cards pass through the gate. The time of entrance/exit of persons is irregular.

Consequently, the frequency of communication of data read from the radio IC card by the card reader becomes irregular, and the time of wait until the beginning of data communication increases.

Even if the frequency of data communication is irregular, the card reader is required to constantly send signals and to always wait for data from the radio IC card.

An object of the present invention is to provide a radio IC card and a method of manufacturing the same, wherein a semiconductor element is electrically connected to an antenna coil and the radio IC card can be obtained at low cost without the need to use an expensive mounting apparatus.

Another object of the invention is to provide a radio IC card and a method of manufacturing the same, as well as a data read/write apparatus, wherein energy saving can be achieved irrespective of the life of a cell.

Still another object of the invention is to provide a radio tag and a method of manufacturing the same, wherein a semiconductor element is electrically connected to an antenna coil and the radio tag can be obtained at low cost without the need to use an expensive mounting apparatus.

Still another object of the invention is to provide a radio tag and a method of manufacturing the same, wherein energy saving can be achieved irrespective of the life of a cell.

According to an aspect of the present invention, there is provided a radio IC card comprising: a board having at least two rectangular-spiral antennas formed thereon; and a semiconductor element having a rectangular-spiral antenna formed on a surface thereof, the semiconductor element being mounted on the board such that the antenna on the semiconductor element is situated opposed to one of the at least two antennas on the board.

In this radio IC card, the antenna on the semiconductor element is formed by bonding a piece of bonding wire among a plurality of electrode pads formed on the surface of the semiconductor element.

The antenna on the semiconductor element is formed of a metallic film.

A layer of the antenna formed of the metallic film and a layer of an insulating film are laminated on the surface of the semiconductor element.

The antenna is provided on each of upper and lower surfaces of the semiconductor element.

The semiconductor element is provided with a layer for formation of an electric element.

One of the antennas formed on the board has substantially the same shape as the antenna formed on the semiconductor element, and the other of the antennas on the board is greater in size than the one of the antennas on the board.

One of the antennas on the board and the other of the antennas on the board are electrically connected.

One of the antennas on the board and the antenna on the semiconductor device are electromagnetically connected.

The antenna is formed over the semiconductor element, with an insulating film interposed.

The antenna is formed over the semiconductor element, with a magnetic film interposed.

An insulating film is formed on each of the antennas on the board.

An insulating film, in which magnetic particles are dispersed, is formed on each of the antennas on the board.

The semiconductor element and the substrate are integrally sealed with resin.

According to another aspect of the invention, there is provided a method of manufacturing a radio IC card, the method comprising the steps of: forming a rectangular-spiral antenna on a surface of a semiconductor element; forming at least two rectangular-spiral antennas on a board; and disposing the antenna formed on the semiconductor element such that the antenna formed on the semiconductor element is opposed to one of the antennas formed on the board.

In this method, the antenna on the surface of the semiconductor element is formed by a thin-film patterning process.

The antenna on the surface of the semiconductor element is formed by a printing process.

The antenna on the surface of the semiconductor element is formed such that a plurality of electrode pads are provided on the surface of the semiconductor element and the electrode pads are connected by means of wire bonding.

The at least two antennas on the board are integrally formed.

The method includes a step of integrally sealing the semiconductor element and the board with resin.

According to another aspect of the invention, there is provided a radio IC card having at least one rectangular-spiral antenna and one semiconductor element mounted thereon, wherein a cavity portion is provided near the antenna and a permanent magnet is movably provided within the cavity portion.

The permanent magnet is movable in a direction of a central axis of the antenna.

The permanent magnet is rotatably provided within the cavity portion.

The antenna serves both for power supply to the semiconductor element and for data communication.

According to another aspect of the invention, there is provided a method of manufacturing a radio IC card, the method comprising the steps of: mounting at least one semiconductor element and one rectangular-spiral antenna on a first casing body in which a recess portion is formed in advance; inserting a permanent magnet movably in the recess portion; and attaching a second casing body to the first casing body provided with the at least one semiconductor element and one antenna and the permanent magnet.

According to another aspect of the invention, there is provided a data reader/writer apparatus comprising: a radio IC card on which at least one rectangular-spiral antenna and a semiconductor element are mounted; and read/write means for performing data communication with the semiconductor element mounted on the radio IC card, the read/write means having a permanent magnet for inducing an electromotive force in the antenna mounted on the radio IC card by crossing a magnetic field over the antenna.

According to another aspect of the invention, there is provided a radio IC card having at least one data communication antenna and one semiconductor element mounted thereon, the radio IC card comprising a piezoelectric element connected to the semiconductor element.

The piezoelectric element is used as a board, and the at least one antenna and one semiconductor element are mounted on the piezoelectric element.

Electrodes are provided on both sides of the piezoelectric element, and these electrodes are electrically connected to at least the semiconductor element.

According to another aspect of the invention, there is provided a method of manufacturing a radio IC card, the method comprising the steps of: attaching at least one data communication antenna and one semiconductor element to a first casing body; attaching a piezoelectric element to the first casing body; and adhering a second casing body to the first casing body.

According to another aspect of the invention, there is provided a method of manufacturing a radio IC card, the method comprising the steps of: attaching at least one data communication antenna and one semiconductor element on a board formed of a piezoelectric element; and applying an outer coating to the board on which the antenna and the semiconductor element are attached.

According to another aspect of the invention, there is provided a data read/write apparatus comprising: a radio IC card having at least one data communication antenna and one semiconductor element mounted thereon and including a piezoelectric element connected to the semiconductor element; and read/write means for performing data communication with the semiconductor element by means of the antenna, the read/write means including a pressing mechanism for pressing the piezoelectric element of the radio IC card, thereby producing an electric charge in the piezoelectric element.

According to another aspect of the invention, there is provided a radio IC card comprising: a semiconductor element having a rectangular-spiral antenna formed on a surface thereof; a board having at least three rectangular-spiral antennas formed thereon such that one of the at least three antennas is situated, opposed to the antenna of the semiconductor element; a cavity portion provided near one of the other antennas on the board; and a permanent magnet provided movably in the cavity portion.

In this radio IC card, on the board there are provided: an antenna situated to be opposed to the antenna on the semiconductor element; a communication antenna electrically connected to the antenna; and a power supply antenna electrically connected to the communication antenna, a magnetic flux of the permanent magnet being crossed over the power supply antenna.

The antennas are sealed with an insulating material in which magnetic particles are dispersed.

According to another aspect of the invention, there is provided a method of manufacturing a radio IC card, the method comprising the steps of: mounting at least one semiconductor element and at least three rectangular-spiral antennas on a first casing body in which a recess portion is formed in advance; inserting a permanent magnet movably in the recess portion; and attaching a second casing body to the first casing body.

In this method, the method includes the steps of: storing the permanent magnet movably in a case; and mounting the case in the recess portion.

The first and second casing bodies are formed of an insulating material in which magnetic particles are dispersed.

According to another aspect of the invention, there is provided a radio tag, wherein a rectangular-spiral antenna is formed on a surface of a semiconductor element.

In this radio tag, the antenna on the semiconductor element is formed by bonding a piece of bonding wire among a plurality of electrode pads formed on the surface of the semiconductor element.

The antenna on the semiconductor element is formed of a metallic film.

A layer of the antenna formed of the metallic film and a layer of an insulating film are laminated on the surface of the semiconductor element.

The antenna is provided on each of upper and lower surfaces of the semiconductor element.

The semiconductor element is provided with a layer for formation of an electric element.

The antenna is provided over the semiconductor element, with an insulating film interposed.

The antenna is formed over the semiconductor element, with a magnetic film interposed.

The antenna is formed on the semiconductor element, with an insulating film containing dispersed magnetic particles interposed.

The semiconductor element having the antenna formed on the surface thereof is sealed with resin.

According to another aspect of the invention, there is provided a method of manufacturing a radio tag, the method comprising the steps of: forming an insulating film over a surface of a semiconductor wafer on which a plurality of semiconductor elements are formed; forming rectangular-spiral antennas on the insulating film at positions corresponding to the semiconductor elements; and dicing the semiconductor elements out of the semiconductor wafer.

In this method, the antenna formed on the surface of each of the semiconductor elements is formed by a thin-film patterning process.

The antenna formed on the surface of each of the semiconductor elements is formed by a printing process.

The antenna on each of the semiconductor elements is formed by bonding a piece of bonding wire among a plurality of electrode pads formed on the surface of the semiconductor element.

Each of the semiconductor elements, on the surface of which the antenna is formed, is sealed with resin.

According to the above radio IC card and the method of manufacturing the same, as well as the data read/write apparatus and the radio tag and the method of manufacturing the same, the semiconductor element and antenna coil are connected electrically, and not physically. Without using expensive mounting apparatuses, these can be manufactured cost-effectively. Furthermore, energy saving can be achieved irrespective of the life of the cell.

This summary of the invention does not necessarily describe all necessary features so that the invention may also be a sub-combination of these described features.

The invention can be more fully understood from the following detailed description when taken in conjunction with the accompanying drawings, in which:

FIG. 1 is a perspective view of a conventional radio IC card;
FIG. 2 is a cross-sectional view of the conventional radio IC card;
FIG. 3 is an electric circuit diagram of the conventional IC card;
FIG. 4 schematically shows the structure of another conventional IC card;
FIG. 5 schematically shows the structure of another conventional IC card;
FIG. 6 is a cross-sectional view of the radio IC card shown in FIG. 5;
FIG. 7A shows a step of manufacturing a radio tag according to a first embodiment of the present invention;
FIG. 7B shows a step of manufacturing the radio tag according to the first embodiment;
FIG. 7C shows a step of manufacturing the radio tag according to the first embodiment;
FIG. 7D shows a step of manufacturing the radio tag according to the first embodiment;
FIG. 8A illustrates a process of manufacturing another example of the radio tag according to the first embodiment;
FIG. 8B is a cross-sectional view of the radio tag in FIG. 8A;
FIG. 8C is a partial cross-sectional view of the radio tag in FIG. 8B;
FIG. 8D is a cross-sectional view of the manufactured radio tag according to this process;
FIG. 9A shows a process of manufacturing the radio tag using a wire bonding method;
FIG. 9B is a side view of this radio tag;
FIG. 10 shows a modification of the radio tag according to the first embodiment;
FIG. 11 shows a modification of the radio tag according to the first embodiment;
FIG. 12 shows a modification of the radio tag according to the first embodiment;
FIG. 13A shows a step of manufacturing a radio IC card according to a second embodiment of the invention;
FIG. 13B shows a step of manufacturing the radio IC card according to the second embodiment;
FIG. 13C shows a step of manufacturing the radio IC card according to the second embodiment;
FIG. 13D shows a step of manufacturing the radio IC card according to the second embodiment;
FIG. 13E shows a step of manufacturing the radio IC card according to the second embodiment;
FIG. 14 is a cross-sectional view of the manufactured IC card;
FIG. 15 is an electric circuit diagram of the radio IC card;
FIG. 16 is a view for describing electromagnetic induction coupling between first and second antenna coils;
FIG. 17A shows a structure of a radio IC card according to a third embodiment of the invention;
FIG. 17B is a cross-sectional view of the radio IC card;
FIG. 18 is an exploded perspective view of the radio IC card;
FIG. 19 is a flow chart of manufacture of the radio IC card;
FIG. 20A is a diagram illustrating the generation of induction electromotive force due to a permanent magnet;
FIG. 20B is a diagram illustrating the generation of induction electromotive force due to the permanent magnet;
FIG. 21A shows a structure of a radio IC card on which a permanent magnet is rotatably mounted;
FIG. 21B is a partial cross-sectional view of the radio IC card shown in FIG. 21A;
FIG. 22A shows a structure of a radio IC card in a data read/write apparatus according to a fourth embodiment of the invention;
FIG. 22B is a cross-sectional view of the radio IC card;
FIG. 23 schematically shows a structure of a reader/writer in the data read/write apparatus;
FIG. 24 is an exploded perspective view of the radio IC card;

FIG. 25 is a view for explaining supply of power from the reader/writer to the radio IC card;
FIG. 26 is a view for explaining the supply of power from the reader/writer to the radio IC card;
FIG. 27 shows a structure of a radio IC card according to a fifth embodiment of the invention;
FIG. 28 shows a structure of a modification of the radio IC card as applied to an automatic wicket;
FIG. 29A shows a structure of a radio IC card according to a sixth embodiment of the invention;
FIG. 29B is a cross-sectional view of the radio IC card;
FIG. 30 is a view for explaining a piezoelectric effect of a piezoelectric element;
FIG. 31 is an electric circuit diagram of the radio IC card;
FIG. 32 is an exploded perspective diagram of the radio IC card;
FIG. 33 is a flow chart of manufacture of the radio IC card;
FIG. 34A shows a structure of a radio IC card according to a seventh embodiment of the invention;
FIG. 34B is a cross-sectional view of the radio IC card;
FIG. 35 is an exploded perspective view of the radio IC card;
FIG. 36 is a flow chart of manufacture of the radio IC card;
FIG. 37A shows an example of dimensions of the manufactured IC card;
FIG. 37B shows an example of dimensions of the radio IC card;
FIG. 38 shows a structure of a data reader/writer apparatus according to an eighth embodiment of the invention;
FIG. 39 is a view for describing power supply to the radio IC card in the apparatus;
FIG. 40A shows a structure of a radio IC card according to a ninth embodiment of the invention;
FIG. 40B is a cross-sectional view of the radio IC card;
FIG. 41A shows a manufacturing step of the radio IC card;
FIG. 41B shows a manufacturing step of the radio IC card;
FIG. 41C shows a manufacturing step of the radio IC card;
FIG. 41D shows a manufacturing step of the radio IC card;
FIG. 42 is a cross-sectional view of an IC chip portion in the radio IC card;
FIG. 43 is an exploded perspective view of the radio IC card; and
FIG. 44 is a flow chart of manufacture of the radio IC card.

(First Embodiment)

A first embodiment of the present invention will now be described with reference to the accompanying drawings.

FIGS. 7A to 7D illustrate steps of manufacturing a radio tag.

FIG. 7A shows a semiconductor wafer 20 on which a plurality of ICs are formed.

An insulating protection film 21 is formed on the surface of the semiconductor wafer 20, as shown in FIG. 7B. The insulating protection film 21 is formed of, e.g. P-SiN (PSG: Phosphosilicate Glass). The thickness of the insulating protection film 21 is in a range from 0.75 μm to 0.4 μm. The insulating protection film 21 may be formed of, for example, a metal oxide such as silicon dioxide, a resin such as polyimide, or air gap.

As is shown in FIG. 7C, a number of wound antennas (hereinafter referred to as "antenna coils") 22 are formed on the insulating protection film 21. The antenna coils 22 are formed of, e.g. gold-plated wire. Alternatively, the antenna coils 22 may be formed of thin-film patterns of Cu, Al, etc., or by printing conductive paste of Cu, etc.

Thereafter, the semiconductor wafer 20 is diced into IC chips 23, as shown in FIG. 7D.

Thus, radio tags provided with antenna coils are manufactured. The size of each radio tag is, for example, 4 mm (length) × 3 mm (width) × 0.3 mm (height).

The above-described radio tag has a data control function and a memory function which are achieved by the IC chip 23. Data transmission with the outside or power supply from the outside can be effected through the antenna coil 22.

According to the first embodiment, as described above, the insulating protection film 21 is formed on the surface of the semiconductor wafer 20, and the antenna coil 22 is formed on the insulating protection film 21. The semiconductor wafer 20 is then diced and the radio tags are formed. Thus, the IC chips 23 are electrically connected to the antenna coils 22 without physical connection. There is no need to use expensive apparatuses, such as flip-chip bonders or wire bonders, in order to mount the IC chips.

There is no need to conduct a process management, for example, for considering heat-resistance in resin-molding, and the reliability is enhanced.

The antenna coil 22 is formed on the IC chip 23, and the resultant structure is merely mounted. Therefore, the small-sized, inexpensive radio tag can be obtained.

A description will now be given of another example of the manufacture of the radio tag according to the first embodiment.

FIGS. 8A to 8D schematically illustrate manufacturing steps of the radio tag. FIG. 8A shows a plan view and a cross-sectional view. FIG. 8B is a cross-sectional view of the radio tag, FIG. 8C is an enlarged view of portion 8C in FIG. 8B, and FIG. 8D is a cross-sectional view of the manufactured radio tag.

An IC chip 23 applied to this example has a square shape with each side of, e.g. about 10 mm, and a thickness of about 20 μm at a minimum.

An insulating protection film 21 is formed on the surface of the IC chip 23. The insulating protection film 21 is formed of, e.g. silicon dioxide or a polyimide resin. The thickness of the insulating protection film 21 is about 10 to 100 μm. The insulating protection film 21 may be formed of a magnetic film such as ferrite, instead of silicon dioxide or a polyimide resin.

Magnetic particles may be dispersed in the insulating protection film 21. With the formation of the magnetic film, an inductance component of the antenna coil 22 which is to be formed subsequently can be increased. The insulating protection film 21 may be an air gap formed by etching silicon dioxide.

A conductive via-hole 24, which is a through-hole, is formed in the insulating protection film 21, as shown in FIG. 8B.

A rectangular spiral antenna coil (pattern coil) 22 is formed on the insulating protection film 21. The antenna coil 22 is formed of a conductive film of Al, Cu, Au, etc. The antenna coil 22 is thinly formed, with a pattern width and a pattern interval being in a range of several μm to several-ten μm. The antenna coil 22 may be formed by means of printing of a conductive paste of, e.g. Ag, Cu, etc.

Subsequently, the IC chip 23 is molded with a mold resin 25, as shown in FIG. 8D. For example, if the mold resin 25 is an epoxy resin, etc., transfer molding is adopted. If the mold resin 25 is PP (polypropylene), PPS (polyphenylsulfone), etc., injection molding is adopted. Thus, a radio tag with an outside shape of about 10 mm × 10 mm and a thickness of about 1 mm.

FIGS. 9A and 9B are schematic views showing another example of the radio tag which is manufactured by using wire bonding. FIG. 9A is a plan view and a FIG. 9B is a side view.

As is shown in FIG. 9A, electrodes 26 are formed at four corner portions on the surface of the IC chip 23. Each electrode 26 has a square shape with each side about 30 μm to 100 μm long.

The electrodes 26 are interconnected by a bonding wire element 27. The bonding of electrodes 26 is performed from the outer peripheral side toward the central side. As a result, a rectangular-helical antenna coil is formed. The bonding wire element 27 has a diameter of, e.g. about 10 μm to 100 μm and is formed of Au, Al or Cu.

The radio tag is thus manufactured.

In the process of manufacturing this radio tag, the formation of an insulating protection film is not needed, as shown in FIG. 9B, and the pattern resistance can be reduced sine the bulk-type coil material is used.

A modification of the manufacture of the radio tag according to the first embodiment will now be described.

FIG. 10 shows a multi-layer structure in which antenna coils 22 and insulating protection films 21 are formed in two tiers on the surface of the IC chip 23. By virtue of this structure, the number of turns of the antenna coils 22 is increased.

FIG. 11 shows a structure in which through-holes 28 are formed in the IC chip 23. Antenna coils 22 are formed on upper and lower surfaces of the IC chip 23. The antenna coils 22 are electrically connected through the through-holes 28.

FIG. 12 shows a radio tag with multi-functions, wherein various electric elements such as a capacitor 29, in addition to antenna coils 22, are provided on the IC chip 23. In the capacitor 29, an induction-type thick-film material of, e.g. titanium dioxide, lead perovskite, etc. is used.

Needless to say, with the above examples of the radio tag, too, the IC chip 23 and antenna coil 22 are connected electrically, and not physically. Without using expensive mounting apparatuses, the radio tags can be manufactured cost-effectively.

(2) A radio IC card (non-contact data carrier) according to a second embodiment of the invention will now be described with reference to FIGS. 13A to 13E.

A radio tag, like the first embodiment, is first manufactured.

An insulating protection film 21 is formed, as shown in FIG. 7B, on the surface of the semiconductor wafer 20 shown in FIG. 7A. The insulating protection film 21 is formed of, e.g. P-SiN (PSG: Phosphosilicate Glass). The thickness of the insulating protection film 21 is in a range from 0.75 μm to 0.4 μm. The insulating protection film 21 may be formed of, for example, a metal oxide such as silicon dioxide, a resin such as polyimide, or air gap.

As is shown in FIG. 7C, the antenna coil 22 (hereinafter referred to as "first antenna coil 22") is formed on the insulating protection film 21 by gold plating. The first antenna coils 22 may be formed of thin-film patterns of Cu, Al, etc., or by printing conductive paste of Cu, etc.

Thereafter, the semiconductor wafer 20 is diced into IC chips 23, as shown in FIG. 7D.

On the other hand, a second antenna coil 31 and a third antenna coil 32 are formed, as shown in FIG. 13B, on a surface of a module board 30 shown in FIG. 13A.

The second antenna coil 31 has substantially the same shape as the first antenna coil 32 formed on the radio tag.

Since the third antenna coil 32 is used for communication with the outside of the radio IC card or for power supply from the outside, it has a greater number of turns and a greater shape than the second antenna coil 31.

The second and third antenna coils 31 and 32 are electrically connected to constitute a closed loop circuit.

The second and third antenna coils 31 and 32 are simultaneously formed on the surface of the module board 30, for example, by a subtractive method, as in the formation of a regular printed circuit board.

The second and third antenna coils 31 and 32 may be formed by an additive method. The second and third antenna coils 31 and 32 may be formed by fixing coils of coated wire on the module board 30. Alternatively, the antenna coils may be formed of a combination of printed wire and wire coils.

Specifically, the second and third antenna coils 31 and 32 are both formed by etching Ag, Al, etc.

Alternatively, the second and third antenna coils 31 and 32 may both be formed by a printing method using Ag paste, or formed of coils of Cu. Furthermore, the second antenna coil 31 may be formed by printing or etching, while the third antenna coil 32 may be formed of coils.

In a subsequent step shown in FIG. 13C, an insulating film 33 is formed on the second antenna coil 31. The insulating film 33 is formed of a semi-hardened epoxy resin with a thickness of, e.g. 20 μm. For example, the insulating film 33 is formed by attaching an insulating adhesive film of a semi-hardened epoxy resin. The insulating film 33 may be formed of some other insulative resin such as polyimide or a metal oxide.

In the next step illustrated in FIG. 13D, the IC chip 23 (see FIG. 7D) is opposed to, and disposed on, the second antenna coil 31 on the module board 30.

In this case, the IC chip 23 is mounted in a face-down fashion. The mounting is performed under a suitable pressure such that the second antenna coil 31 is opposed to the first antenna coil 22 of the IC chi 23 with the insulating film 33 interposed.

In addition, the mounting is performed such that the gap between the first antenna coil 22 and second antenna coil 31 is mechanically controlled and the gap is set at about 20 μm or less.

In the mounting step, in order to completely harden the insulating adhesive film of, e.g. semi-hardened epoxy resin, which forms the insulating film 33, it is heated at about 200°C to 120°C for 10 to 120 seconds and fixed on the module board 30.

For example, the material of the insulating adhesive film may be applied in a viscous liquid phase. In this case, where the maintenance of the insulating film 33 is difficult under pressure, the height of the film may be controlled. For example, the insulating film 33 may be maintained by using a spacer of a polyester film with a thickness of, e.g. 10 μm, which serves also as the insulating film 33.

Subsequently, as shown in FIG. 13E, the entire module board 30 with the IC chip 23 is sealed with resin and coated with the polyester film 33. At last, the radio IC card 34 is obtained after printing and punching.

FIG. 14 is a cross-sectional view of the manufactured radio IC card 34. The method of forming the radio IC card is, for example, injection molding (e.g. insertion molding) using, e.g. a polyester resin, or pressing molding using, e.g. a vinyl chloride sheet.

FIG. 15 is an electric circuit diagram of the radio IC card 34.

Since the first antenna coil 22 of the IC chip 23 is disposed to be opposed to the second antenna coil 31 of the module board 30, electromagnetic induction coupling is effected between the first antenna coil 22 and second antenna coil 31.

Accordingly, if the third antenna coil 32 receives electric waves from the outside, an electromotive force occurs in the third antenna coil 32. The electromotive force is supplied to the second antenna coil 31 connected to the third antenna coil 32.

At the time current begins to flow in the second antenna coil 31, an electric field is generated at the second antenna coil 31.

This electric field acts on the first antenna coil 22 located near and opposed to the second antenna coil 31, and an electromotive force is induced in the first antenna coil 22.

This electromotive force is supplied to the IC circuit 35. In this manner, external electric waves are converted to power to be supplied to the IC circuit 35, through the third, second and first antenna coils 32, 31 and 22.

On the other hand, if current is output from the IC circuit 35, the current is supplied to the first antenna coil 22. At the time the current begins to flow through the first antenna coil 22, an electric field is generated at the first antenna coil 22.

This electric field acts on the second antenna coil 31 located near and opposed to the first antenna coil 22, and an electromotive force is induced in the second antenna coil 31.

The induced electromotive force is supplied to the third antenna coil 32. This causes electric waves to be radiated from the third antenna coil 32.

The electromagnetic induction coupling between the first antenna coil 32 and second antenna coil 31 will now be described with reference to FIG. 16.

Assume that there are two single-turn coils having loop planes parallel to an xz-plane, i.e. those corresponding to the first antenna coil 22 and second antenna coil 31. A distance between the first and second antenna coils 22 and 31 is d.

An intensity H, at a location of the first antenna coil 22, of a magnetic field produced by a current Ia flowing in the second antenna coil 31 can be found by considering a y-axis component Hy alone and given by the Biot-Savart's law as follows:

$$\begin{aligned} Hy &= \frac{Ia(2\pi ra)\left\{ra / \sqrt{(ra^2 + d^2)}\right\}}{4\pi(ra^2 + d^2)} \\ &= \frac{ra^2 \cdot Ia}{2(ra^2 + d^2)^{3/2}} \qquad \ldots(1) \\ &= \alpha Ia \end{aligned}$$

$$\alpha = \frac{ra^2}{2(ra^2 + d^2)^{3/2}} \qquad (2)$$

It is understood from above that the magnetic field Hy is proportional to the current Ia. An electromotive force Vb produced by electromagnetic induction in the first antenna coil 22 is expressed by

$$Vb = -(d\Phi b/dt) \qquad (3)$$

where $\Phi b$ is the magnetic flux density of the first antenna coil 22.

The relationship between the magnetic flux density $\Phi b$ of the first antenna coil 22 and the magnetic field Hy is expressed by

$$\Phi b = \mu\ Hy\ (\mu\text{: magnetic permeability}) \qquad (4)$$

Accordingly, using equations (1), (3) and (4), the electromotive force Vb is given by

$$\begin{aligned} Vb &= -(d\Phi b/dt) \\ &= -\mu\ (dHy/dt) \\ &= -\alpha\mu\ (dIa/dt) \qquad \ldots(5) \end{aligned}$$

where $\mu$ is a constant determined by material.

The electromotive force Vb occurs in the first antenna coil 22 due to a temporal variation in the current Ia flowing through the second antenna coil 31.

It is understood from the above equation (2) that $\alpha$ increases as the distance d between the first and second antenna coils 22 and 31 decreases and the sensitivity for communication becomes higher as the distance d between the first and second antenna coils 22 and 31 decreases.

According to the second embodiment, the first antenna coil 22 is formed on the surface of the IC chip 23, and the second and third antenna coils 31 and 32 are formed on the module board 30. The IC chip 23 is disposed on the module board 30 such that the first antenna coil 22 of the IC chip 23 is opposed to the second antenna coil 31. Thus, unlike the prior art, the radio IC card wherein the IC circuit 35 and third antenna coil 32 are electrically connected, without physical connection, can be obtained.

Accordingly, such an expensive mounting apparatus as a flip-chip bonder or a wire bonder is not required to mount the IC chip 23.

In addition, in the case of the resin-molding, a process management, for example, for considering heat-resistance, is needed and the reliability lowers.
Moreover, the degree of freedom for the manufacturing process is high, and the manufacturing cost is reduced.
In the manufacturing of the radio tag according to the second embodiment, the antenna coils 22 are formed of gold-plated wiring elements, thin-film patterns, or by printing conductive paste.
As shown in FIGS. 9A and 9B, however, the first antenna coil 22 may be formed by means of wire bonding.
Alternatively, the first antenna coil 22 may be formed with a multi-layer structure, as shown in FIG. 10.
Alternatively, antenna coils 22 may be formed on the upper and lower surfaces of the IC chip 23, as shown in FIG. 11.
Alternatively, the IC chip 23 may be provided with various electric elements such as capacitor 29 so as to have multi-functions, as shown in FIG. 12.
(3) A third embodiment according to the present invention will now be described.
FIGS. 17A and 17B show the structure of the radio IC card according to the third embodiment. FIG. 17A is a plan view and FIG. 17B is a cross-sectional view.
A carrier body 40 is provided with an IC chip 23, a communication antenna 41 and a power supply coil 42. The communication antenna 41 and power supply coil 42 are formed in rectangular spiral shapes.
The communication antenna 41 and power supply coil 42 are connected to the IC chip 23.
The carrier body 40 is formed of, e.g. polystyrene (PS), polyethylene terephthalate (PET) or vinyl chloride. The size of the carrier body is, e.g. 86 mm × 54 mm × 3 mm.
The communication antenna 41 and power supply coil 42 are formed, for example, by winding fine conductors twice or more, or by winding electric lines twice or more by means of deposition, etc. For example, coated copper-wire coils, copper-wire coils or aluminum-wire coils are used for the communication antenna 41 and power supply coil 42.
A space (hereinafter referred to as "cavity") 43 is defined inside the power supply coil 42. A permanent magnet 44 is movably provided within the cavity 43.
The permanent magnet 44 has a plate shape. One surface side of the permanent magnet 44 is magnetized with an N-pole, and the other surface side is magnetized with an S-pole. As is shown in FIG. 17B, the permanent magnet 44 is disposed to be movable in the direction of the central axis (S1) of the power supply coil 42. The permanent magnet 44 is formed of, e.g. an Alnico molded magnet, a Ba ferrite magnet, a rare-earth cobalt magnet, carbon steel, tungsten steel, KS steel, or Cunife. The size of the permanent magnet 44 is, e.g. 20 mm × 40 mm × 1 mm.
A method of manufacturing the above radio IC card will now be described with reference to an exploded perspective view of FIG. 18 and a flow chart of FIG. 19. In the flow chart of FIG. 19, triangular symbol ▽ denotes the provision of structural elements, and circular symbol ○ denotes manufacturing steps.
As is shown in FIG. 18, the carrier body 40 is a combination of a first casing body (lower card casing body) 40a and a second casing body (upper card casing body) 40b.
The lower card casing body 40a is provided with recess portions 45 to 47 for receiving the IC chip 23, communication antenna 41 and power supply coil 42.
The upper card casing body 40b is provided with a cavity 43 for insertion of the permanent magnet 44.
To start with, as shown in FIG. 19, an IC chip 23 and a board 48 for the IC chip 23 are provided.
In step #1, the IC chip 23 is mounted on the board 48.
In step #2, the IC chip 23 mounted on the board 48 is set in the recess portion 45 in the lower card casing body 40a. In this step, the IC chip 23 is adhered to the recess portion 45.
The communication antenna 41 and power supply coil 42 are supplied to the manufacturing line.
Leads 41a and 42a for connection with the terminals of the board 48 extend from the communication antenna 41 and power supply coil 42.
In step #3, the communication antenna 41 and power supply coil 42 are set in the recess portions 46 and 47 in the lower card casing body 40a.
The leads 41a and 42a of the communication antenna 41 and power supply coil 42 are connected to the terminals of the board 48 by means of soldering.
The permanent magnet 44 is supplied to the manufacturing line. In step #4, the permanent magnet 44 is inserted in the cavity 43 in the upper card casing body 40b.
Subsequently, the lower card casing body 40a on which the IC chip 23, communication antenna 41 and power supply coil 42 are mounted is supplied to the manufacturing line, and the upper card casing body 40b in which the permanent magnet 44 is inserted are supplied to the manufacturing line.
In step #5, the lower card casing body 40a and upper card casing body 40b are combined and adhered to each other, whereby the carrier body 40 is formed.
In step #6, printing is effected on the surface of the carrier body 40.
At last, the manufactured radio IC card is examined.
The operation of the thus manufactured radio IC card will now be described.

If the radio IC card is carried by a person, etc., the entire body thereof moves. Thereby the permanent magnet 44 in the cavity 43 is moved.

The magnetic flux of the permanent magnet 44 crosses the power supply coil 42, and as a result an electromotive force is induced in the power supply coil 42. The induced electromagnetic force is supplied to the IC chip 23.

This operation will now be described more specifically with reference to FIGS. 20A and 20B which are enlarged partial views of the power supply coil 42.

If the radio IC card has moved, the permanent magnet 44 moves in the direction of the central axis sl of the power supply coil 42 within the cavity 43.

Consider a case where the permanent magnet 44 is located at an end portion of the cavity 43, as shown in FIG. 20A, and a case where the permanent magnet 44 is located at a central portion of the cavity 43, as shown in FIG. 20B. Suppose that an upper surface of the permanent magnet 44 has an S-pole, and a lower surface thereof has an N-pole.

When the permanent magnet 44 is located at an end portion of the cavity 43, as shown in FIG. 20A, the flux density B within the power supply coil 42 takes a minimum value. When the permanent magnet 44 is located at a central portion of the cavity 43, as shown in FIG. 20B, the flux density takes a maximum value.

Accordingly, if the entire radio IC card is slightly moved, for example, by the hand of the user, the flux density B within the power supply coil 42 varies. The variation in the flux density B induces an electromotive force in the power supply coil 42. The electromotive force is supplied as power to the IC chip 23.

The permanent magnet 44 is movably provided within the cavity 43, but it may be provided, for example, in a rotatable manner.

FIGS. 21A and 21B show structures of the radio IC card. FIG. 21A is a partial plan view, and FIG. 21B is a partial cross-sectional view.

Both end portions of a plate-like permanent magnet 49 are rotatably supported by support members 50 and 51 within the cavity 43. The support member 51 is coupled to a dial 53. The dial 53 functions to rotate the permanent magnet 49 in the direction of arrow s2 from the outside, as shown in FIG. 21B.

In general, an induction electromotive force v occurs in a primary coil in such a direction as to cancel a temporal variation in magnetic flux within the coil. The electromotive force v is expressed by

$$v = - d\Phi/dt \tag{6}$$

where Φ is the flux, and t is time.

If the magnetic flux is B, the in-coil area is S, permeability is μ and magnetic field intensity is H,

$$\begin{aligned}\Phi &= B \cdot S \\ &= \mu \cdot H \cdot S \qquad \ldots(7)\end{aligned}$$

The induction electromotive force v is expressed by

$$v = \mu \cdot S \cdot dH/dt \tag{8}$$

An example of calculation of induction electromotive force v is shown below. Since the cavity 43 is located within the power supply coil 42, the permeability of air is approximated on the basis of that of vacuum as follows:

$$\mu = 1.25 \times 10^{6}\ [H/m] \tag{9}$$

The permanent magnet 44 is rotatable within the radio IC card. The permanent magnet 44 has a plate shape and a size of 2 mm × 20 mm, and is formed of, e.g. $SmCo_5$.

The coercive force of the permanent magnet 44 is expressed by

$$\begin{aligned}H &= 2.87 \times 10^{4}\ [Oe] \\ &= 2.28 \times 10^{6}\ [A/m] \qquad \ldots(10)\end{aligned}$$

If the permanent magnet 44 is rotated at 10 rps and the number of turns of the power supply coil 42 is set at 500, the electromotive force v is given by

$$v = 500\mu \cdot S \cdot 2H/10^{-1} = 1.14\ [V] \quad \ldots(11)$$

In this example, an electromotive force of about 1 [V] is obtained.

According to the third embodiment, the cavity 43 is formed within the power supply coil 42 mounted on the radio IC card, and the permanent magnet 44 is movably provided within the cavity 43. Thus, electric energy due to induction electromotive force v can be supplied to the radio IC card by the permanent magnet 44 and, e.g. the manual operation, without using electric energy due to a cell or an electromagnetic coil.

Accordingly, exchange of a cell is not required, and power consumption in the standby state of the reader/writer can be reduced to achieve energy saving. Thus, the radio IC card with simple structure can be manufactured. For example, compared to the cell-built-in type radio IC card, the energy saving ratio of power supply is 100% and no waste cell is produced.

(4) A fourth embodiment of the present invention will now be described. The structural parts common to those shown in FIGS. 17A and 17B are denoted by like reference numerals, and a detailed description thereof is omitted.

The fourth embodiment relates to a data read/write apparatus using a radio IC card. FIGS. 22A and 22B show a structure of the radio IC card, and FIG. 23 schematically shows a structure of a radio IC card reader/writer 50.

In the radio IC card, the IC chip 23, communication antenna 41 and power supply coil 42 are mounted on the carrier body 40. The IC chip 23 is connected to the communication antenna 41 and power supply coil 42.

A method of manufacturing the radio IC card will now be described with reference to an exploded perspective view of FIG. 24.

The carrier body 40 is formed by combining a lower card casing body 40a and an upper card casing body 40b.

Like the radio IC card shown in FIG. 18, the lower card casing body 40a, the lower card casing body 40a is provided with recess portions 45 to 47 for receiving the IC chip 23, communication antenna 41 and power supply coil 42.

To start with, the IC chip 23 and board 48 are prepared. The IC chip 23 is mounted on the board 48. The IC chip 23 is set in the recess portion 45 in the lower card casing body 40a.

Then, the communication antenna 41 and power supply coil 42 are prepared. These antennas 41 and 42 have leads 41a and 42a for connection with terminals of the board 48.

The communication antenna 41 and power supply coil 42 are set in the recess portions 46 and 47 in the lower card casing body 40a.

The leads 41a and 42a are connected to the terminals of the board 48 by means of, e.g. soldering.

The lower card casing body 40a, on which the IC chip 23, communication antenna 41 and power supply coil 42 have been mounted, is combined with the upper card casing body 40b. The lower card casing body 40a and the upper card casing body 40b are adhered to each other to constitute the carrier body 40.

Following the above, printing is effected on the surface of the carrier body 40.

At last, the manufactured radio IC card is inspected.

On the other hand, the reader/writer 50 reads/writes data from/in the radio IC card which is situated as shown in FIG. 23.

The reader/writer 50 includes a read/write antenna 51 which corresponds in position to the communication antenna 41 of the radio IC card. The reader/writer 50 also includes a permanent magnet 52 which corresponds in position to the power supply coil 42 of the radio IC card.

The power supply operation of the data read/write apparatus with the above construction, by which power is supplied to the radio IC card, will now be described.

If the carrier body 40 is moved toward the reader/writer 50, the power supply coil 42 in the radio IC card approaches the permanent magnet 52 in the reader/writer 50, as shown in FIGS. 25 and 26. With the power supply coil 42 approaching the permanent magnet 52, the flux density B within the power supply coil 42 varies and an electromotive force is induced in the power supply coil 42. The induced electromotive force is supplied to the IC chip 23.

According to the fourth embodiment, the reader/writer 50 is provided with the permanent magnet 52. By approaching the carrier body 40 to the reader/writer 50, the electromotive force is induced in the power supply coil 42 and it is supplied to the IC chip 23 of the radio IC card. Like the first embodiment, electric energy can be supplied to the radio IC card when data read/write is effected by the reader/writer 50, without using electric energy due to a cell or an electromagnetic induction coil. Therefore, no exchange of a cell is required, and power consumption in the standby state of the reader/writer 50 can be reduced to achieve energy saving. Thus, the radio IC card with simple structure can be manufactured.

(5) A fifth embodiment of the present invention will now be described. The structural parts common to those shown in FIGS. 17A and 17B are denoted by like reference numerals, and a detailed description thereof is omitted.
FIG. 27 is an exploded perspective view of a radio IC card.
A method of manufacturing the radio IC card will now be described.
The carrier body 40 is formed by combining a lower card casing body 40a and an upper card casing body 40b.
The lower card casing body 40a is provided with recess portions 61 and 62 for receiving the IC chip 23 and a communication/power-supply coil 60.
The upper card casing body 40b is provided with the cavity 43 for receiving the permanent magnet 44.
To begin with, the IC chip 23 and board 48 are prepared.
The IC chip 23 is mounted on the board 48.
The IC chip 23 mounted on the board 48 is set in the recess portion 61 in the lower card casing body 40a.
The communication/power-supply coil 60 is prepared. The coil 60 has leads 60a for connection with terminals of the board 48. The communication/power-supply coil 60 is set in the recess portion 62 in the lower card casing body 40a. The leads 60a are connected to the terminals of the board 48 by means of, e.g. soldering.
Then the permanent magnet 44 is prepared. The permanent magnet 44 is inserted in the cavity 43 in the upper card casing body 40b.
The lower card casing body 40a, on which the IC chip 23 and communication/power-supply coil 60 are mounted, and the upper card casing body 40b, in which the permanent magnet 44 is inserted, are combined and adhered to each other. Thus the carrier body 40 is constituted.
Following the above, printing is effected on the surface of the carrier body 40. Finally, the radio IC card is inspected.
The operation of the radio IC card thus manufactured will now be described.
If the radio IC card is carried by the user and moved, the permanent magnet 44 in the cavity 43 is moved.
With the movement of the permanent magnet 44, the magnetic flux of the permanent magnet 44 crosses the communication/power-supply coil 60. Consequently, an electromotive force is induced in the communication/power-supply coil 60. The induced electromotive force is supplied to the IC chip 23.
Needless to say, according to the fifth embodiment, the same advantages as with the first embodiment can be obtained with use of the communication/power-supply coil 60.
The third to fifth embodiments may be modified as follows.
For example, as shown in FIG. 28, a plurality of permanent magnets 71 may be arranged in an automatic wicket 70. The radio IC card shown in FIGS. 22A and 22B is made to pass by the permanent magnets 71. At this time, the flux density B within the power supply coil 42 varies, and an electromotive force induced in the power supply coil 42 is supplied to the IC chip 23.
(6) A sixth embodiment of the present invention will now be described with reference to the accompanying drawings.
FIG. 29A shows a structure of a radio IC card, and FIG. 29B is a cross-sectional view of the radio IC card.
An IC chip 23 and a communication antenna 41 are mounted on a carrier body 80. The communication antenna 41 is electrically connected to the IC chip 23.
The carrier body 80 is formed of, e.g. polystyrene (PS), polyethylene terephthalate (PET), vinyl chloride, etc.
The communication antenna 41 is formed of, e.g. a coated copper wire coil, a copper wire coil or an aluminum wire coil.
A piezoelectric element 81 electrically connected to the IC chip 23 is mounted on the carrier body 80. Electrodes 82a and 82b are provided at both ends of the piezoelectric element 81. The electrodes 82a and 82b are electrically connected to the IC chip 23.
The piezoelectric element 81 has such a piezoelectrical effect that when pressure is applied to the piezoelectric element 81, as shown in FIG. 30, it is polarized to have positive and negative charges (+,-). The piezoelectric element 81 is formed of, e.g. Rochelle salt, barium titanate, potassium dihydrogenphosphate, ammonium hydrogenphosphate, lithium sulfate, lithium niobate, zinc oxide, polyvinyl difluoride, antimony iodide-sulfide, or zinc zirconate-titanate.
FIG. 31 is an electric circuit diagram of the above radio IC card.
The communication antenna 41 and electrodes 82a and 82b are connected to the IC chip 23. The electrodes 82a and 82b are provided at both ends of the piezoelectric element 61. The piezoelectric element 81 serves as a power supply for the IC chip 23.
A method of manufacturing the radio IC card will now be described with reference to an exploded perspective view of FIG. 32 and a flow chart of FIG. 33.
The carrier body 80, as shown in FIG. 32, is formed by combining a first casing body (lower card casing body) 80a and a second casing body (upper card casing body) 80b.
A recess portion 83 for receiving the piezoelectric element 81 is formed in the lower card casing body 80a. Although not shown, the lower card casing body 80a is provided with recess portions for receiving the IC chip 23 and communication antenna 41.
To start with, as shown in FIG. 33, the IC chip 23 and board 84 are prepared. In step #10, the IC chip 23 is mounted on the board 84. In the next step #11, the board 84 as a COB (chip-on-board) 85 is set in the recess portion 83 in the lower card casing body 80a.

The communication antenna 41 is supplied to the manufacturing line. The communication antenna 41 has leads 41a for connection with the terminals of the COB 85. In step #12, the communication antenna 41 is set in the recess portion in the lower card casing body 80a.

The leads 41a of the communication antenna 41 are connected to the terminals of the COB 85 by means of, e.g. soldering.

Subsequently, the piezoelectric element 81 and the terminals 82a and 82b to be provided at both ends of the piezoelectric element 81 are supplied. The electrodes 82a and 82b have leads 86 and 87 for connection with the terminals of the COB 85. The electrodes 82a and 82b are provided at both ends of the piezoelectric element 81.

In step #13, the piezoelectric element 81 with the electrodes is set in the recess portion in the lower card casing body 80a. The leads 86 and 87 of the electrodes 82a and 82b are connected to the terminals of the COB 85 by means of, e.g. soldering.

In step #14, the lower card casing body 80a on which the COB 85, communication antenna 41 and piezoelectric element 81 with electrodes are mounted, is combined with, and adhered to, the upper card casing body 80b. Thus, the carrier body 80 is constituted.

In step #15, printing is effected on the surface of the carrier body 80, and at last the manufactured radio IC card is inspected.

The size of the manufactured radio IC card is 86 mm × 54 mm, each side of the IC chip is 3 mm, each size of the communication antenna 41 is 45 mm, and the size of the piezoelectric element 81 is 30 mm × 45 mm × 2 mm.

The operation of the radio IC card will now be described.

If pressure is applied to the piezoelectric element 81 of the radio IC card, it is polarized to have positive and negative charges (+,-), as shown in FIG. 30. An electromotive force is produced at the electrodes 82a and 82b of the piezoelectric element 81, and it is supplied to the IC chip 23.

Accordingly, if pressure is applied to the piezoelectric element 81 of the radio IC card by a pressurizing mechanism or the hand of the user, the electromotive force produced by the piezoelectric element 81 is supplied to the IC chip 23.

As has been described above, according to the sixth embodiment, the electromotive force produced by the piezoelectric element 81 is supplied to the IC chip 23. Thus, like the third embodiment, no exchange of a cell is required, energy saving is realized, and the radio IC card with simple structure is obtained. For example, compared to the cell-built-in type non-contact data carrier, the energy saving ratio of power supply is 100% and no waste cell is produced. Therefore, the life of the apparatus can be increased while the apparatus can be operated with clean energy.

(7) A seventh embodiment of the present invention will now be described with reference to the accompanying drawings.

FIG. 34A shows the structure of a radio IC card and FIG. 34B is a cross-sectional view of the radio IC card.

An IC chip 23 and communication antenna 41 are mounted on the carrier body 90. The communication antenna 41 is electrically connected to the IC chip 23.

The carrier body 90 is formed of, e.g. polystyrene (PS), polyethylene terephthalate (PET) or vinyl chloride.

The communication antenna 41 is formed of, e.g. coated copper-wire coils, copper-wire coils or aluminum-wire coils.

The carrier body 90 incorporates a plate-like piezoelectric element (hereinafter referred to as "piezoelectric element board") 91. The piezoelectric element board 91 serves as a board of the radio IC card body.

The piezoelectric element board 91 has such a piezoelectrical effect that when pressure is applied to the piezoelectric element board 91, it is polarized to have positive and negative charges (+,-). Like the sixth embodiment, the piezoelectric element board 91 is formed of, e.g. Rochelle salt, barium titanate, potassium dihydrogenphosphate, ammonium hydrogenphosphate, lithium sulfate, lithium niobate, zinc oxide, polyvinyl difluoride, antimony iodide-sulfide, or zinc zirconate-titanate.

The IC chip 23 and communication antenna 41 are mounted on the piezoelectric element board 91.

The electrodes 92a and 92b are provided on both surfaces of the piezoelectric element board 91. The electrodes 92a and 92b are electrically connected to the IC chip 23. It is preferable to form the electrodes 92a and 92b as large as possible on both surfaces of the piezoelectric element board 91.

A method of manufacturing the radio IC card will now be described with reference to an exploded perspective view of FIG. 35 and a flow chart of FIG. 36.

As is shown in FIG. 35, the carrier body 90 is formed by providing the piezoelectric element board 91 with a lower outside sheet 90a and an upper outside sheet 90b.

The communication antenna 41 and electrodes 92a and 92b are formed on the piezoelectric element board 91.

To begin with, as shown in FIG. 35, the IC chip 23 and piezoelectric element board 91 are supplied to the manufacturing line. In step #20, the IC chip 23 is mounted on the piezoelectric element board 91.

In step #21, the lower outside sheet 70a and upper outside sheet 70b are attached, by means of pressing or laminating, to both surfaces of the piezoelectric element board 91 on which the IC chip 23 is mounted. Thus, the carrier body 90 is formed.

In step #22, printing is effected on the surface of the carrier body 90.

At last, the manufactured radio IC card is inspected.

FIGS. 37A and 37B show an example of the size of the manufactured radio IC card. The size of the entire radio IC card is 86 mm × 54 mm × 3 mm.

The operation of the manufactured radio IC card will now be described.

If pressure is applied to the piezoelectric element board 91, it is polarized to have positive and negative charges (+,-), as shown in FIG. 30. An electromotive force is produced at the electrodes 92a and 92b of the piezoelectric element board 91, and it is supplied to the IC chip 23.

Accordingly, if pressure is applied to the piezoelectric element board 91 by a pressurizing mechanism or the hand of the user, the electromotive force produced by the piezoelectric element board 91 is supplied to the IC chip 23.

As has been described above, according to the seventh embodiment, the electromotive force produced by the piezoelectric element board 91 used as the board of the carrier body 90 is supplied to the IC chip 23. Thus, like the third embodiment, no exchange of a cell is required, energy saving is realized, and the radio IC card with simple structure is obtained.

For example, compared to the cell-built-in type radio IC card, the energy saving ratio of power supply is 100% and no waste cell is produced. Therefore, the life of the apparatus can be increased while the apparatus can be operated with clean energy.

(8) An eighth embodiment of the present invention will now be described with reference to the accompanying drawings.

FIG. 38 shows the structure of a data read/write apparatus.

The data read/write apparatus comprises, for example, the radio IC card 100 according to the seventh embodiment, as a radio IC card, and a reader/writer 101 for reading/writing data from/in the radio IC card 100.

Since the radio IC card 100 has the same structure as the radio IC card according to the seventh embodiment, a description thereof is omitted.

On the other hand, in the state in which the radio IC card 100 is set in position, the reader/writer 101 reads/writes data from/in the radio IC card 100.

The reader/writer 101 comprises a read/write antenna 102, which is so situated as to correspond in position to the communication antenna 41 of the radio IC card 100, and a data processing unit 103, connected to the read/write antenna 102, for controlling data read/write, processing data and storing data.

The reader/writer 101 has a carrier passage 105 communicating with a carrier insertion opening 104. A pair of rollers 106a and 106b are provided along the carrier passage 105.

When the radio IC card 100 is set in the reader/writer 101, the rollers 106a and 106b serve as a pressing mechanism for pressing the electrodes 92a and 92b provided on the piezoelectric element board 91 of radio IC card 100.

In addition to the rollers 106a and 106b, a plurality of rollers are provided along the carrier passage 105 in order to guide the radio IC card 100 through the carrier passage 105.

A power supply operation in the data read/write apparatus with the above structure, by which power is supplied to the radio IC card 100, will now be described.

If the radio IC card 100 is inserted into the carrier insertion opening 104 in the reader/writer 101, the radio IC card 100 is automatically guided into the carrier passage 105 and set in a data read/write position.

At this time, the rollers 106a and 106b press the electrodes 92a and 92b provided on the piezoelectric element board 91 of radio IC card 100, as shown in FIG. 39.

If pressure is applied to the piezoelectric element board 91, it is polarized to have positive and negative charges (+,-). An electromotive force is produced at the electrodes 92a and 92b of the piezoelectric element board 91, and it is supplied to the IC chip 23.

Thereby, data is transmitted between the radio IC card 100 and reader/writer 101 by means of their communication antennas 41 and 102.

In the eighth embodiment of the invention, the piezoelectric element board 91 of radio IC card 100 is pressed by the paired rollers 106a and 106b of reader/writer 101 to produce an electromotive force, and the electromotive force is supplied to the IC chip 23. Accordingly, like the fourth embodiment, electric energy can be supplied to the radio IC card 100 when data read/write is effected by the reader/writer 101, without using electric energy due to a cell or an electromagnetic induction coil.

Therefore, no exchange of a cell is required, and power consumption in the standby state of the reader/writer 101 can be reduced to achieve energy saving. Thus, the radio IC card 100 with simple structure can be manufactured.

(9) A ninth embodiment of the invention will now be described with reference to the accompanying drawings.

FIGS. 40A and 40B show the structure of a radio IC card. FIG. 40A is a plan view and FIG. 40B is a cross-sectional view.

An IC chip 23, a communication antenna 41 and a power supply coil 42 are mounted on a carrier body 110.

The communication antenna 41 and power supply coil 42 are formed in a rectangular spiral shape, respectively.

The communication antenna 41 is electrically connected to an antenna coil 31 situated opposed to an antenna coil 22 of the IC chip 23.

The power supply coil 42 is electrically connected to the communication antenna 41.

The power supply coil 110 is formed of, e.g. polystyrene (PS), polyethylene terephthalate (PET) or vinyl chloride.

The communication antenna 41 and power supply coil 42 are formed, for example, by winding fine conductors twice or more, or by winding electric lines twice or more by means of deposition, etc. For example, coated copper-wire coils, copper-wire coils or aluminum-wire coils are used for the communication antenna 41 and power supply coil 42.

A cavity 43 is defined inside the power supply coil 42. A permanent magnet 44 is movably provided within the cavity 43.

The permanent magnet 44 has a plate shape.

One surface side of the permanent magnet 44 is magnetized with an N-pole, and the other surface side is magnetized with an S-pole. As is shown in FIG. 40B, the permanent magnet 44 is disposed to be movable in the direction of the central axis (S1) of the power supply coil 42. The permanent magnet 44 is formed of, e.g. an Alnico molded magnet, a Ba ferrite magnet, a rare-earth cobalt magnet, carbon steel, tungsten steel, KS steel, or Cunife.

A method of manufacturing the radio IC card will now be described with reference to FIGS. 41A to 41D illustrating the respective manufacturing steps.

The IC chip 23 is formed, as in the first embodiment.

In brief, the insulating protection film 21 shown in FIG. 7B is formed on the surface of the semiconductor wafer 20 shown in FIG. 7A.

As is shown in FIG. 7C, the antenna coil 22 of, e.g. gold-plated wire, is formed on the insulating protection film 21.

Thereafter, the semiconductor wafer 20 is diced into IC chips 23, as shown in FIG. 7D.

On the other hand, as shown in FIG. 41B, the communication antenna coil 41 and antenna coil 31 are formed on a surface of a module board 111.

The shape of the antenna coil 31 is substantially the same as that of the antenna coil 22 formed on the IC chip 23.

Since the communication antenna coil 41 is used for communication with the outside, the number of turns of the coil 41 is made greater than that of the antenna coil 31 and the coil 41 is made larger than the coil 31. The communication antenna coil 41 and antenna coil 31 are electrically connected to each other.

The communication antenna coil 41 and antenna coil 31 are simultaneously formed on the surface of the module board 111, for example, by a subtractive method, as in the formation of a regular printed circuit board. These antenna coils 41 and 31 may be formed by an additive method.

These antenna coils 41 and 31 may be formed by fixing coils of coated wire on the module board 111. Alternatively, the antenna coils may be formed of a combination of printed wire and wire coils.

Specifically, the communication antenna coil 41 and antenna coil 31 are both formed by etching Ag, Al, etc. Alternatively, the antenna coils 41 and 31 may both be formed by a printing method using Ag paste, or formed of coils of Cu. Furthermore, the antenna coil 31 may be formed by printing or etching.

In a subsequent step, an insulating film 21 is formed on the antenna coil 31, as shown in FIG. 41C. The insulating film 21 is formed of a semi-hardened epoxy resin with a thickness of, e.g. 20 μm. For example, the insulating film 21 is formed by attaching an insulating adhesive film of a semi-hardened epoxy resin. The insulating film 21 may be formed of some other insulative resin such as polyimide or a metal oxide.

Thereafter, the IC chip 23 is opposed to, and disposed on, the antenna coil 31.

In this case, the IC chip 23 is mounted in a face-down fashion. The mounting is performed under a suitable pressure such that the antenna coil 31 is opposed to the antenna coil 22 of the IC chi 23 with the insulating film 21 interposed.

In addition, the mounting is performed such that the gap between the antenna coil 22 and antenna coil 31 is mechanically controlled and the gap is set at about 20 μm or less. In the mounting step, in order to completely harden the insulating adhesive film of, e.g. semi-hardened epoxy resin, which forms the insulating film 21, it is heated at about 200°C to 120°C for 10 to 120 seconds and fixed on the module board 111.

For example, the material of the insulating adhesive film may be applied in a viscous liquid phase. In this case, where the maintenance of the insulating film 21 is difficult under pressure, the height of the film may be controlled. For example, the insulating film 21 may be maintained by using a spacer of a polyester film with a thickness of, e.g. 10 μm, which serves also as the insulating film 21.

An insulating film 112 is then formed on the module board 111.

The power supply coil 42 is formed on the insulating film 112. The power supply coil 42 is formed, for example, by a subtractive method, as in the formation of a regular printed circuit board.

The power supply coil 42 may be formed by an additive method. The power supply coil 42 may be formed by fixing coils of coated wire on the module board 111. Alternatively, the coil 42 may be formed of a combination of printed wire and a wire coil.

A cavity portion 43 containing a permanent magnet 44 is provided. The permanent magnet 44 is movably provided within the cavity portion 43. The cavity portion 43 is mounted on the insulating film 112.

As is shown in FIG. 41D, the entire module board 111 with the IC chip 23 and cavity portion 43 is sealed with resin 113. Magnetic particles are dispersed in the resin 113.

The entire body of the module board 111 is coated with a polyester film 33. Finally, the radio IC card is obtained after printing and punching.

FIG. 42 is a cross-sectional view of the IC chip of the manufactured radio IC card. The method of forming the radio IC card is, for example, injection molding using, e.g. a polyester resin, or pressing molding using, e.g. a vinyl chloride sheet.

A method of manufacturing the radio IC card will now be described with reference to an exploded perspective view of FIG. 43 and a flow chart of FIG. 44.

As is shown in FIG. 43, the carrier body 110 is a combination of a first casing body (lower card casing body) 110a and a second casing body (upper card casing body) 110b.

The lower card casing body 110a is provided with recess portions 45 to 47 for receiving the IC chip 23, communication antenna 41 and power supply coil 42.

The lower card casing body 110a is provided with a recess portion 120 for electrical connection between the communication antenna 41 and power supply coil 42.

The cavity portion 43 for insertion of the permanent magnet 44 is provided on the upper card casing body 110b.

Magnetic particles are dispersed in both the lower card casing body 110a and upper card casing body 110b.

To start with, as shown in FIG. 44, the IC chip 23 and the board 48 for the IC chip 23 are prepared.

In step #30, the IC chip 23 is mounted on the board 48.

In step #31, the IC chip 23 mounted on the board 48 is set in the recess portion 45 in the lower card casing body 110a. In this case, the IC chip 23 is adhered to the recess portion 45.

Next, the communication antenna 41 and power supply coil 42 are supplied. The communication antenna 41 has leads 41a for connection with the terminals of the substrate 48. The communication antenna 41 also has leads 41b for electrical connection with the power supply coil 42.

The power supply coil 42 has leads 42a for electrical connection with the communication antenna 41.

In step #32, the communication antenna 41 and power supply coil 42 are set in the recess portions 46 and 47 in the lower card casing body 110a. The leads 41a of the communication antenna 41 are connected to the terminals of the board 48 by means of, e.g. soldering.

The leads 41a of the communication antenna 41 and the leads 42a of the power supply coil 42 are electrically connected by means of, e.g. soldering.

The permanent magnet 44 is then supplied. In step #33, the permanent magnet 44 is inserted in the cavity portion 43 on the upper card casing body 110b.

Subsequently, the lower card casing body 110a, on which the IC chip 23, communication antenna 41 and power supply coil 42 are mounted, is supplied. In addition, the upper card casing body 110b in which the permanent magnet 44 is inserted is supplied.

In step #34, the lower card casing body 110a and upper card casing body 110b are combined and adhered to each other. Thus, the carrier body 110 is constituted.

In step #35, printing is effected on the surface of the carrier body 110, and at last the manufactured radio IC card is inspected.

The operation of the radio IC card thus manufactured will now be described.

If the radio IC card is carried by a person, etc., the entire body thereof is moved. Thereby, the permanent magnet 44 in the cavity 43 moves.

The magnetic flux of the permanent magnet 44 crosses the power supply coil 42, thus inducing an electromotive force in the power supply coil 42. The electromotive force is supplied to the IC chip 23 through the communication antenna 41.

As has been described above, according to the ninth embodiment of the invention, electric energy can be supplied to the radio IC card due to the induced electromotive force v, which is produced by, e.g. a manual operation of the permanent magnet 44, without using electric energy due to a cell or an electromagnetic coil.

In this case, since magnetic particles are dispersed in the seal resin 113 or the lower and upper card casing bodies 110a and 110b, the sensitivity of transmission between the communication antenna 41 and IC chip 23 can be enhanced.

Furthermore, since the magnetic particles are dispersed, the electromotive force induced in the power supply coil 42 can be increased and also the power to be supplied to the IC chip 23 increased.

Accordingly, exchange of a cell is not required, and power consumption in the standby state of the reader/writer can be reduced to achieve energy saving. Thus, the radio IC card with simple structure can be manufactured. For example, compared to the cell-built-in type radio IC card, the energy saving ratio of power supply is 100% and no waste cell is produced.

## Claims

1. A radio IC card for data communication with outside, characterized by comprising:

   a board (30) having at least two rectangular-spiral antennas (31, 32) formed thereon; and
   a semiconductor element (23) having a rectangular-spiral antenna (22) formed on a surface thereof, the semiconductor element being mounted on the board such that the antenna (22) on the semiconductor element is situated opposed to one (31) of said at least two antennas on the board (30).

2. A radio IC card according to claim 1, characterized in that said antenna (23) on the semiconductor element is formed by bonding a piece of bonding wire (27) among a plurality of electrode pads (26) formed on the surface of the semiconductor element.

3. A radio IC card according to claim 1, characterized in that the antenna (22) on the semiconductor element is formed of a metallic film.

4. A radio IC card according to claim 1, characterized in that a layer of the antenna (22) formed of a metallic film and a layer of an insulating film (21) are laminated on the surface of the semiconductor element.

5. A radio IC card according to claim 1, characterized in that said antenna (22) is provided on each of upper and lower surfaces of the semiconductor element (23).

6. A radio IC card according to claim 1, characterized in that said semiconductor element (23) is provided with a layer for formation of an electric element (29).

7. A radio IC card according to claim 1, characterized in that one (31) of the antennas formed on the board (30) has substantially the same shape as the antenna (22) formed on the semiconductor element, and the other (32) of the antennas on the board is greater in size than said one (31) of the antennas on the board.

8. A radio IC card according to claim 1, characterized in that one (31) of the antennas on the board and the other (32) of the antennas on the board are electrically connected.

9. A radio IC card according to claim 1, characterized in that one (31) of the antennas on the board and the antenna (22) on the semiconductor device are electromagnetically connected.

10. A radio IC card according to claim 1, characterized in that said antenna (22) is formed over the semiconductor element (23), with an insulating film (21) interposed.

11. A radio IC card according to claim 1, characterized in that said antenna (22) is formed over the semiconductor element (23), with a magnetic film interposed.

12. A radio IC card according to claim 1, characterized in that an insulating film (21) is formed on each of the antennas (31, 32) on the board.

13. A radio IC card according to claim 1, characterized in that an insulating film (21), in which magnetic particles are dispersed, is formed on each of the antennas (31, 32) on the board.

14. A radio IC card according to claim 1, characterized in that said semiconductor element (23) and said substrate (30) are integrally sealed with resin (25).

15. A method of manufacturing a radio IC card for data communication with outside, the method characterized by comprising the steps of:

forming a rectangular-spiral antenna (22) on a surface of a semiconductor element (23);
forming at least two rectangular-spiral antennas (31, 32) on a board (30); and
disposing the antenna (22) formed on the semiconductor element such that the antenna formed on the semiconductor element is opposed to one (31) of said antennas formed on the board.

**16.** A method of manufacturing a radio IC card, according to claim 15, characterized in that the antenna (22) on the surface of the semiconductor element is formed by a thin-film patterning process.

**17.** A method of manufacturing a radio IC card, according to claim 15, characterized in that the antenna (22) on the surface of the semiconductor element is formed by a printing process.

**18.** A method of manufacturing a radio IC card, according to claim 15, characterized in that the antenna (22) on the surface of the semiconductor element is formed such that a plurality of electrode pads (26) are provided on the surface of the semiconductor element and the electrode pads are connected by means of wire bonding.

**19.** A method of manufacturing a radio IC card, according to claim 15, characterized in that said at least two antennas (31, 32) on the board are integrally formed.

**20.** A method of manufacturing a radio IC card, according to claim 15, characterized in that the method includes a step of integrally sealing the semiconductor element (23) and the board (30) with resin (25).

**21.** A radio IC card having at least one rectangular-spiral antenna (42) and one semiconductor element (23) mounted thereon, characterized in that a cavity portion (43) is provided near the antenna and a permanent magnet (44) is movably provided within the cavity portion.

**22.** A radio IC card according to claim 21, characterized in that the permanent magnet (44) is movable in a direction of a central axis of the antenna (42).

**23.** A radio IC card according to claim 21, characterized in that the permanent magnet (44) is rotatably provided within the cavity portion (43).

**24.** A radio IC card according to claim 21, characterized in that the antenna (42) serves both for power supply to the semiconductor element (23) and for data communication.

**25.** A method of manufacturing a radio IC card for data communication with outside, the method characterized by comprising the steps of:

mounting at least one semiconductor element (23) and one rectangular-spiral antenna (41, 42) on a first casing body (40a) in which a recess portion is formed in advance;
inserting a permanent magnet (44) movably in the recess portion; and
attaching a second casing body (40b) to the first casing body provided with said at least one semiconductor element and one antenna and said permanent magnet.

**26.** A data reader/writer apparatus for reading/writing data from/in a radio IC card, the apparatus characterized by comprising:

a radio IC card on which at least one rectangular-spiral antenna (41, 42) and a semiconductor element (23) are mounted; and
read/write means for performing data communication with the semiconductor element mounted on the radio IC card, the read/write means having a permanent magnet (52) for inducing an electromotive force in the antenna mounted on the radio IC card by crossing a magnetic field over the antenna.

**27.** A radio IC card having at least one data communication antenna (41) and one semiconductor element (23) mounted thereon, characterized in that the radio IC card comprises a piezoelectric element (81) connected to the semiconductor element.

**28.** A radio IC card according to claim 27, characterized in that said piezoelectric element (91) is used as a board, and said at least one antenna (41) and one semiconductor element (23) are mounted on the piezoelectric element.

**29.** A radio IC card according to claim 27, characterized in that electrodes (92a, 92b) are provided on both sides of the piezoelectric element (91), and these electrodes are electrically connected to at least said semiconductor element (23).

**30.** A method of manufacturing a radio IC card for data communication with outside, the method characterized by comprising the steps of:

attaching at least one data communication antenna (41) and one semiconductor element (23) to a first casing body (80a);
attaching a piezoelectric element (81) to the first casing body (80a); and
adhering a second casing body (80b) to the first casing body (80a).

**31.** A method of manufacturing a radio IC card, the method characterized by comprising the steps of:

attaching at least one data communication antenna (41) and one semiconductor element (23) on a board (91) formed of a piezoelectric element; and
applying an outer coating to the board (91) on which the antenna and the semiconductor element are attached.

**32.** A data read/write apparatus characterized by comprising:

a radio IC card having at least one data communication antenna (41) and one semiconductor element (23) mounted thereon and including a piezoelectric element (81) connected to the semiconductor element (23); and
read/write means for performing data communication with the semiconductor element (23) by means of the antenna (41), the read/write means including a pressing mechanism (106a, 106b) for pressing the piezoelectric element (81) of the radio IC card, thereby producing an electric charge in the piezoelectric element.

**33.** A radio IC card for data communication with outside, characterized by comprising:

a semiconductor element (23) having a rectangular-spiral antenna (22) formed on a surface thereof;
a board (111) having at least three rectangular-spiral antennas (31, 41, 42) formed thereon such that one (31) of said at least three antennas is situated, opposed to the antenna (22) of the semiconductor element;
a cavity portion (43) provided near one (42) of the other antennas on the board; and
a permanent magnet (44) provided movably in the cavity portion.

**34.** A radio IC card according to claim 33, characterized in that on said board (111) there are provided:

an antenna (31) situated to be opposed to the antenna (22) on the semiconductor element (23);
a communication antenna (41) electrically connected to said antenna; and
a power supply antenna (42) electrically connected to the communication antenna (41), a magnetic flux of the permanent magnet (44) being crossed over the power supply antenna.

**35.** An IC card according to claim 33, characterized in that said antennas are sealed with an insulating material (113) in which magnetic particles are dispersed.

**36.** A method of manufacturing a radio IC card, the method characterized by comprising the steps of:

mounting at least one semiconductor element (23) and at least three rectangular-spiral antennas (31, 41, 42) on a first casing body (100a) in which a recess portion is formed in advance;
inserting a permanent magnet (44) movably in the recess portion; and
attaching a second casing body (l10b) to the first casing body (110a).

**37.** A method of manufacturing a radio IC card according to claim 36, characterized in that the method includes the steps of:

storing the permanent magnet (44) movably in a case; and
mounting the case in the recess portion.

**38.** A method of manufacturing a radio IC card according to claim 36, characterized in that the first and second casing bodies (110a, 110b) are formed of an insulating material in which magnetic particles are dispersed.

**39.** A radio tag for data communication with inside, characterized in that a rectangular-spiral antenna (22) is formed on a surface of a semiconductor element (23).

**40.** A radio tag according to claim 39, characterized in that said antenna (22) on the semiconductor element is formed by bonding a piece of bonding wire (27) among a plurality of electrode pads (26) formed on the surface of the semiconductor element.

**41.** A radio tag according to claim 39, characterized in that the antenna (22) on the semiconductor element is formed of a metallic film.

**42.** A radio tag according to claim 39, characterized in that a layer of the antenna (22) formed of a metallic film (21) and a layer of an insulating film (21) are laminated on the surface of the semiconductor element (23).

**43.** A radio tag according to claim 39, characterized in that said antenna (22) is provided on each of upper and lower surfaces of the semiconductor element (23).

**44.** A radio tag according to claim 39, characterized in that said semiconductor element (23) is provided with a layer for formation of an electric element (24).

**45.** A radio tag according to claim 39, characterized in that the antenna (22) is provided over the semiconductor element (23), with an insulating film (21) interposed.

**46.** A radio tag according to claim 39, characterized in that said antenna (22) is formed over the semiconductor element (23), with a magnetic film interposed.

**47.** A radio tag according to claim 39, characterized in that the antenna (22) is formed on the semiconductor element (23), with an insulating film (21) containing dispersed magnetic particles interposed.

**48.** A radio tag according to claim 39, characterized in that the semiconductor element (23) having the antenna (22) formed on the surface thereof is sealed with resin (25).

**49.** A method of manufacturing a radio tag for data communication with outside, the method characterized by comprising the steps of:

forming an insulating film (21) over a surface of a semiconductor wafer (20) on which a plurality of semiconductor elements (23) are formed;
forming rectangular-spiral antennas (22) on the insulating film at positions corresponding to the semiconductor elements; and
dicing the semiconductor elements (23) out of the semiconductor wafer (20).

**50.** A method of manufacturing a radio tag according to claim 49, characterized in that the antenna (22) formed on the surface of each of the semiconductor elements is formed by a thin-film patterning process.

**51.** A method of manufacturing a radio tag according to claim 49, characterized in that the antenna (22) formed on the surface of each of the semiconductor elements is formed by a printing process.

**52.** A method of manufacturing a radio tag according to claim 49, characterized in that said antenna (22) on each of the semiconductor elements is formed by bonding a piece of bonding wire among a plurality of electrode pads (26) formed on the surface of the semiconductor element.

**53.** A method of manufacturing a radio tag according to claim 49, characterized in that each of the semiconductor elements (23) on the surface of which the antenna is formed is sealed with resin (25).

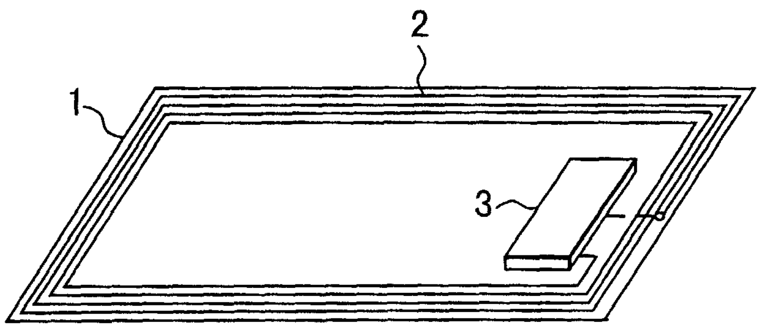


FIG. 1

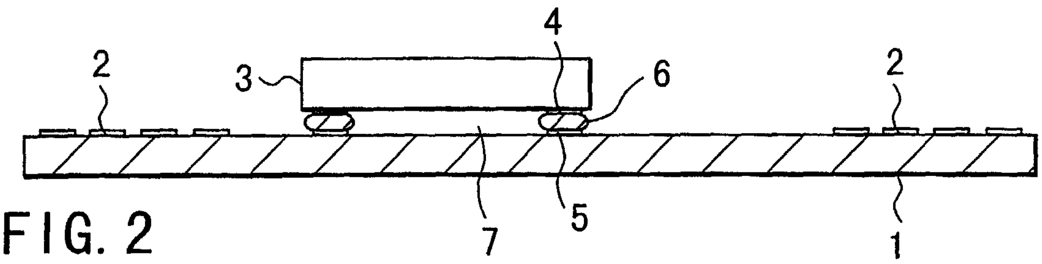


FIG. 2

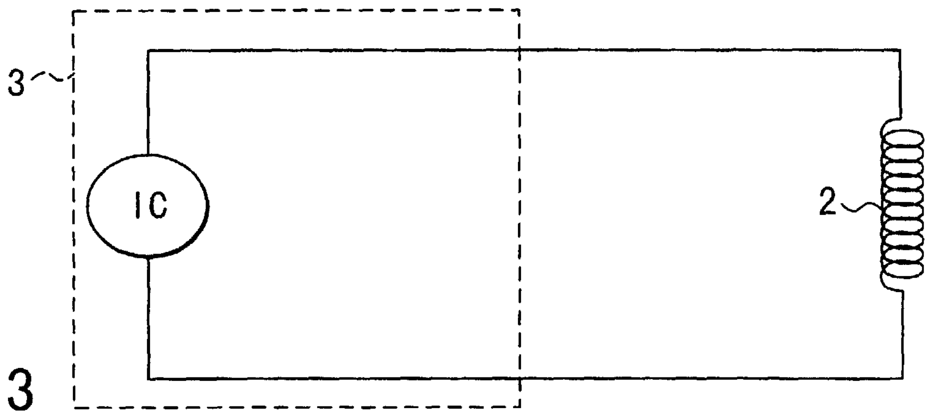


FIG. 3

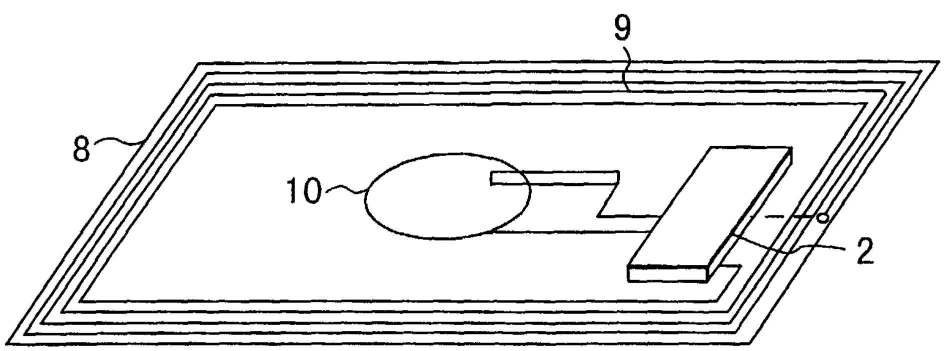


FIG. 4

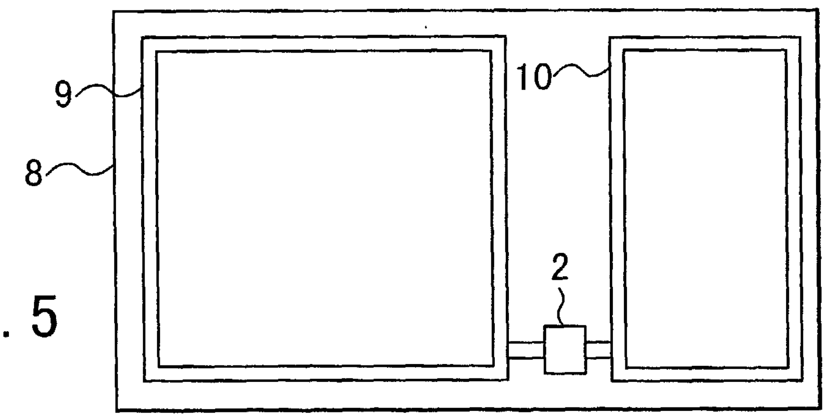


FIG. 5

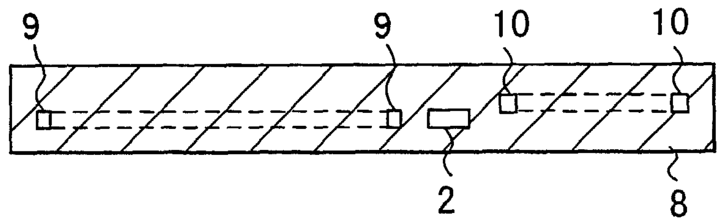


FIG. 6

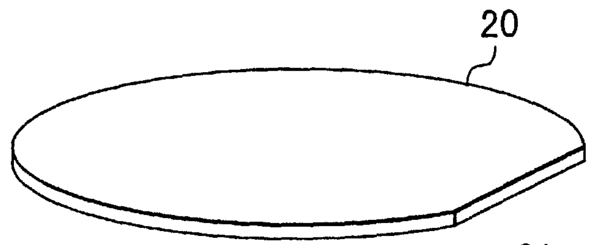


FIG. 7A

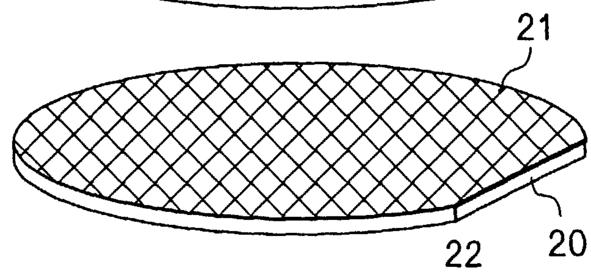


FIG. 7B

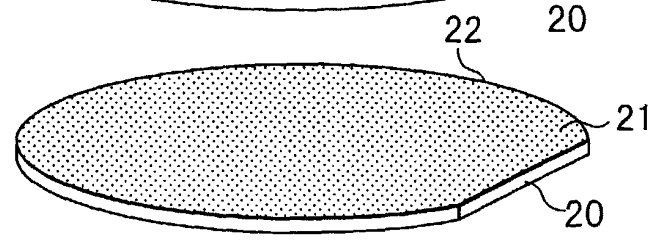


FIG. 7C

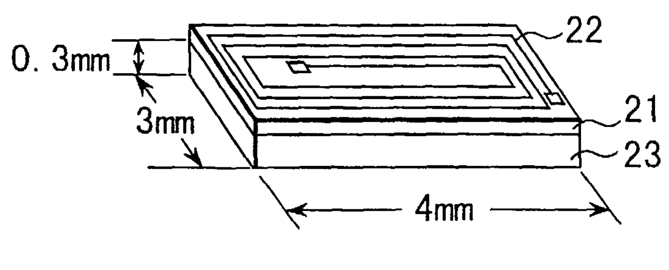


FIG. 7D

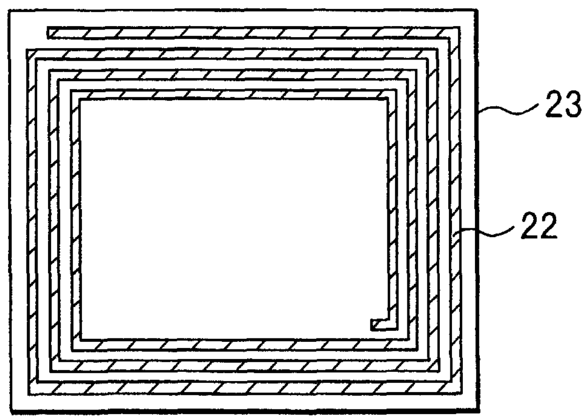


FIG. 8A

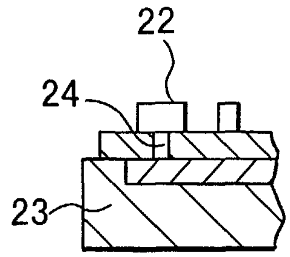


FIG. 8C

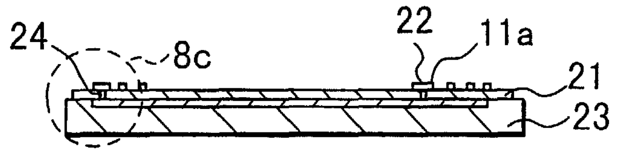


FIG. 8B

FIG. 8D

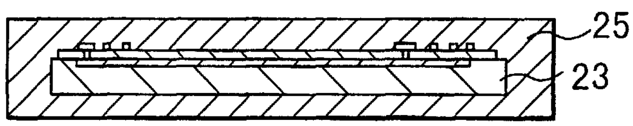


FIG. 9A

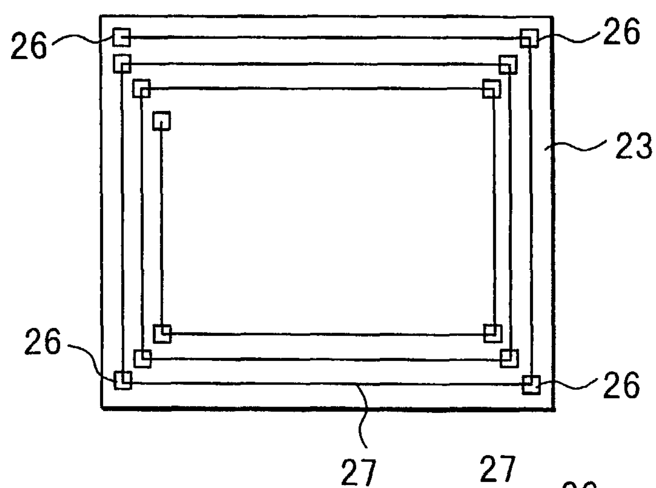


FIG. 9B

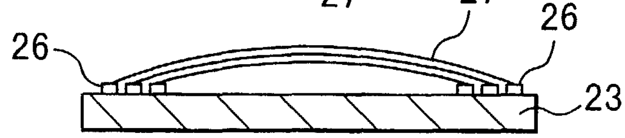

FIG. 10

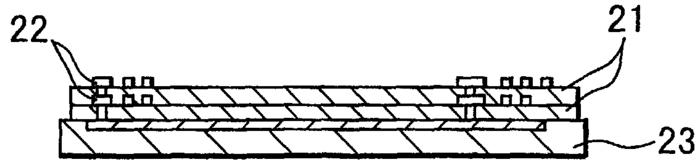


FIG. 11

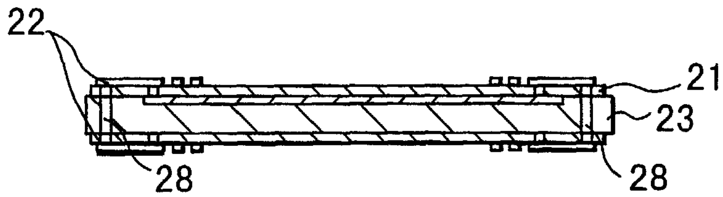


FIG. 12

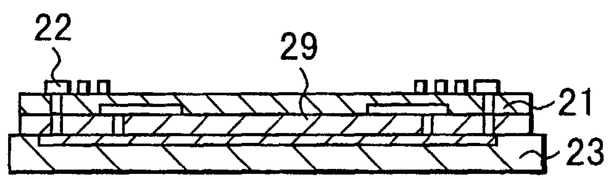


FIG. 13A

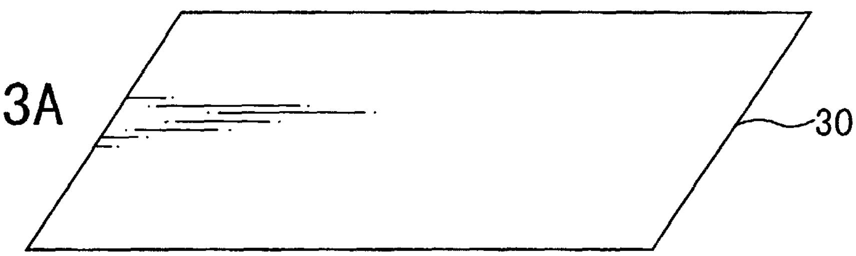


FIG. 13B

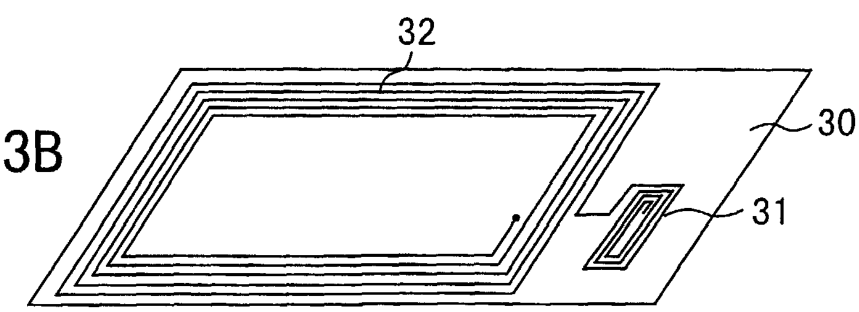


FIG. 13C

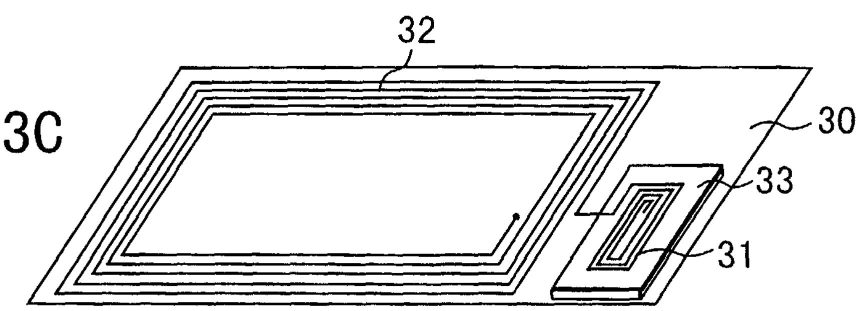

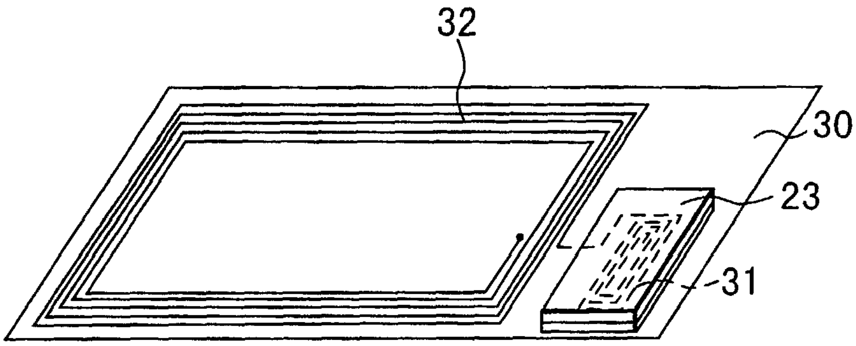


FIG. 13D

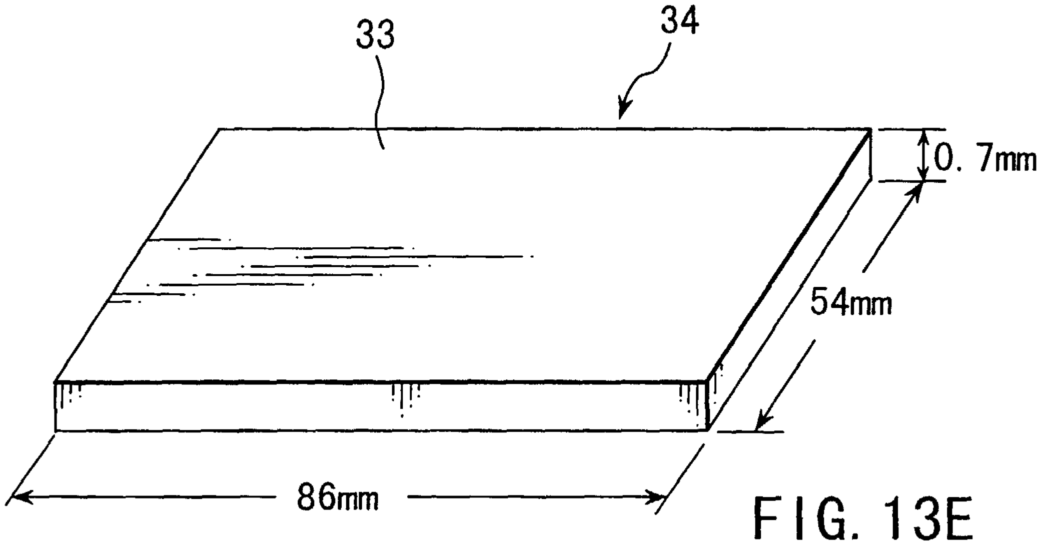


FIG. 13E

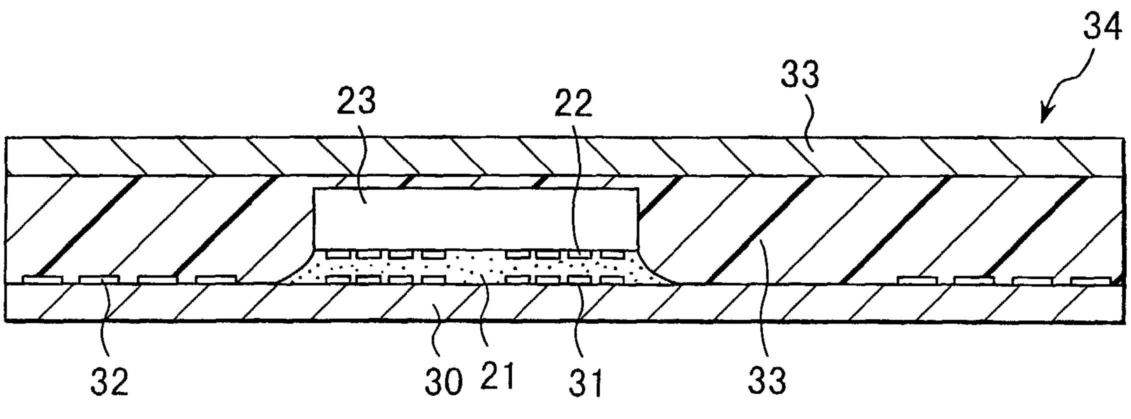


FIG. 14

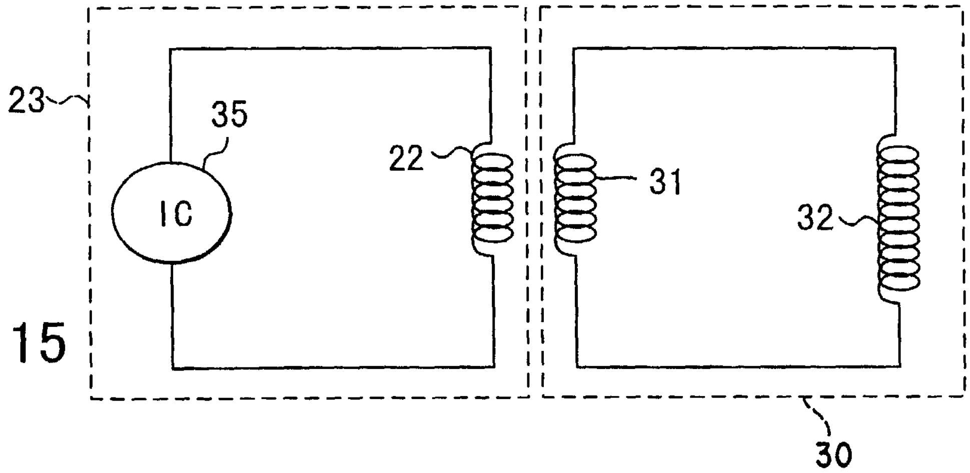


FIG. 15

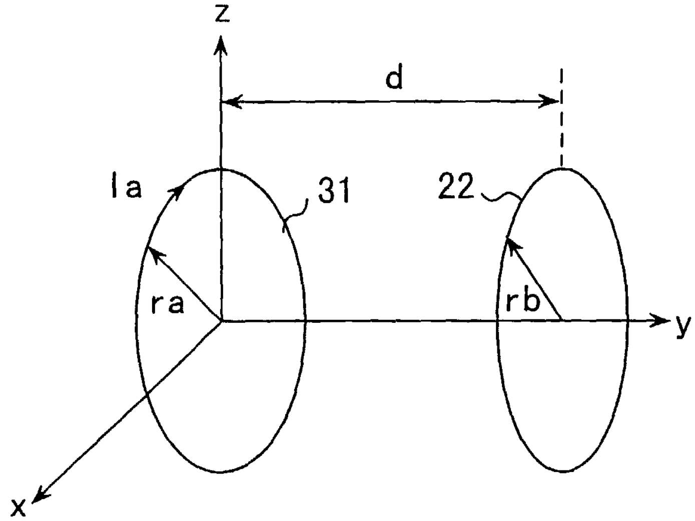


FIG. 16

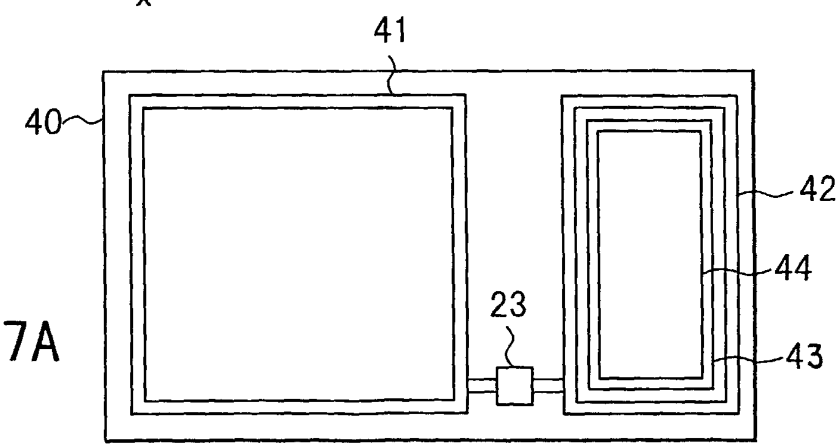


FIG. 17A

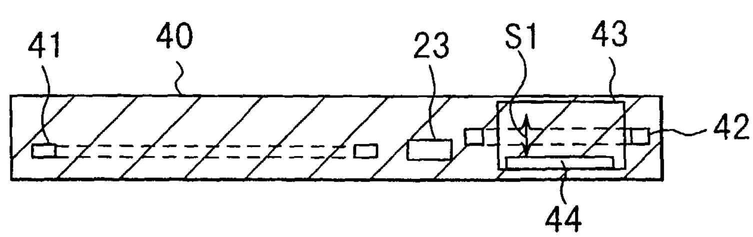


FIG. 17B

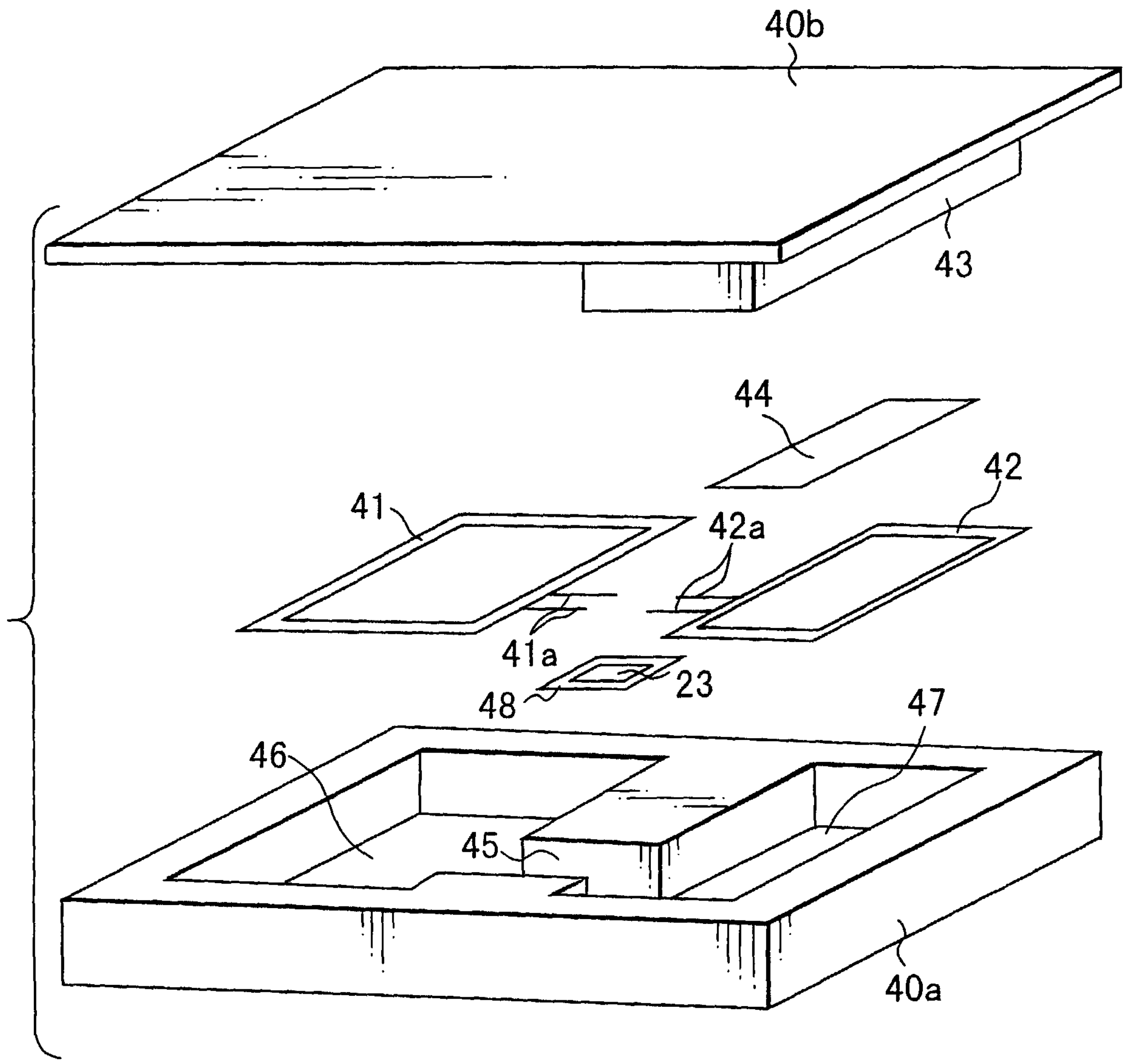


FIG. 18

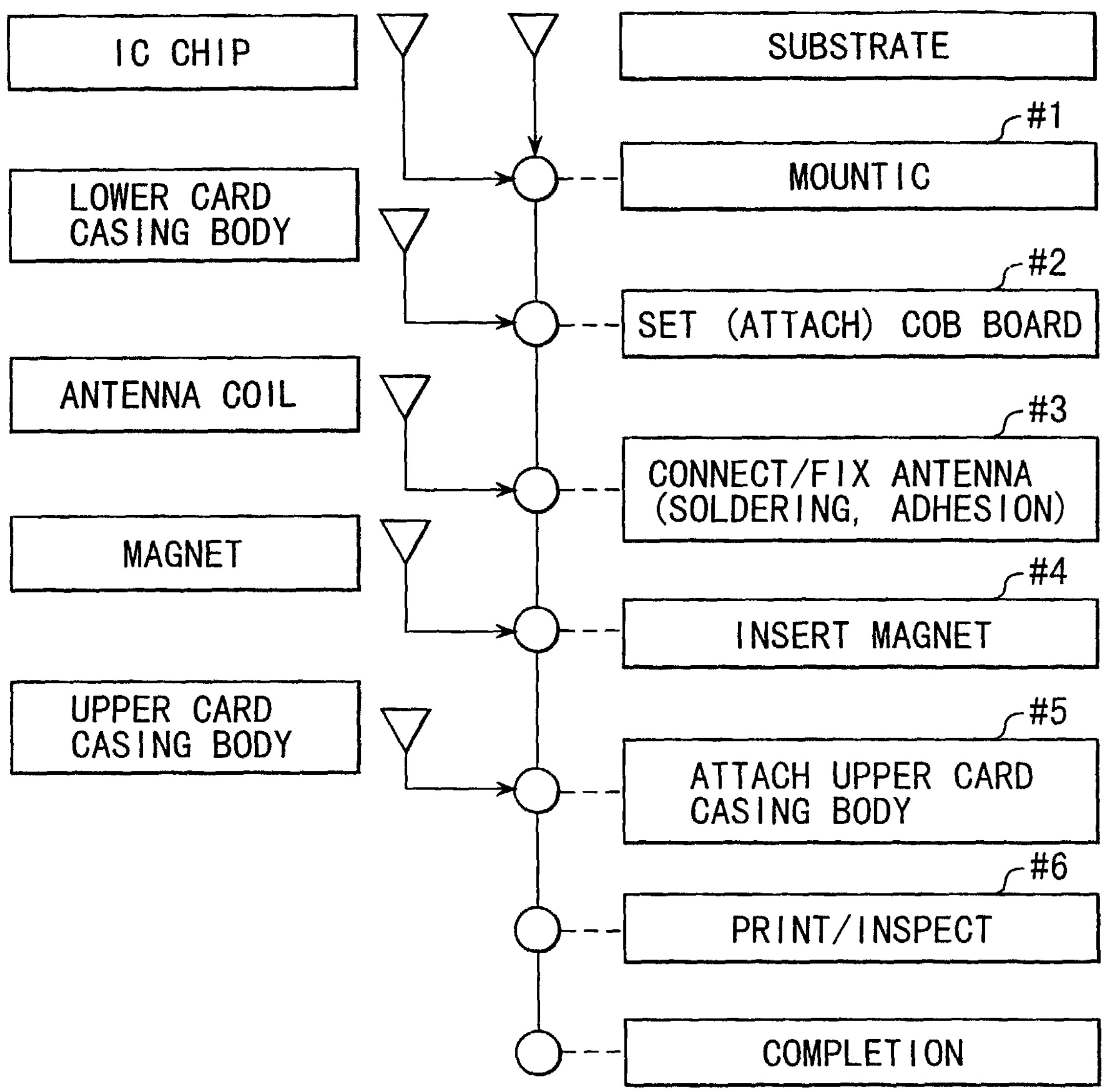
IC CHIP
SUBSTRATE
#1
MOUNTIC
LOWER CARD CASING BODY
#2
SET (ATTACH) COB BOARD
ANTENNA COIL
#3
CONNECT/FIX ANTENNA (SOLDERING, ADHESION)
MAGNET
#4
INSERT MAGNET
UPPER CARD CASING BODY
#5
ATTACH UPPER CARD CASING BODY
#6
PRINT/INSPECT
COMPLETION

FIG. 19

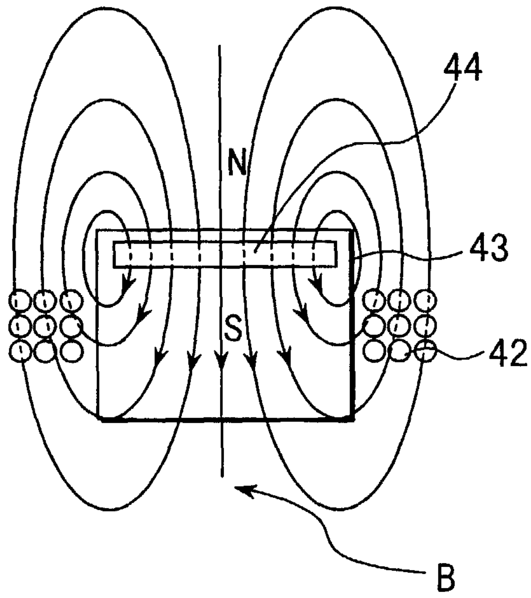


FIG. 20A

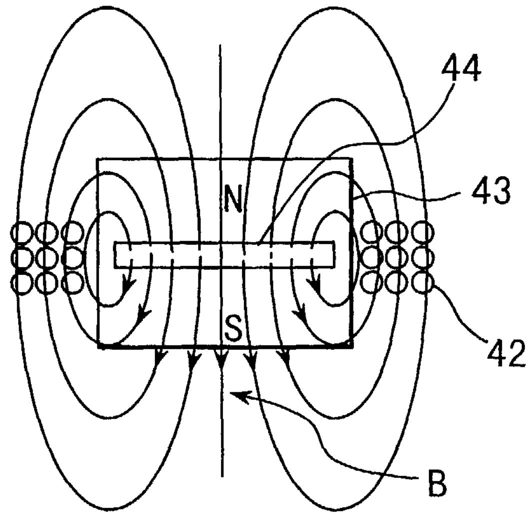


FIG. 20B

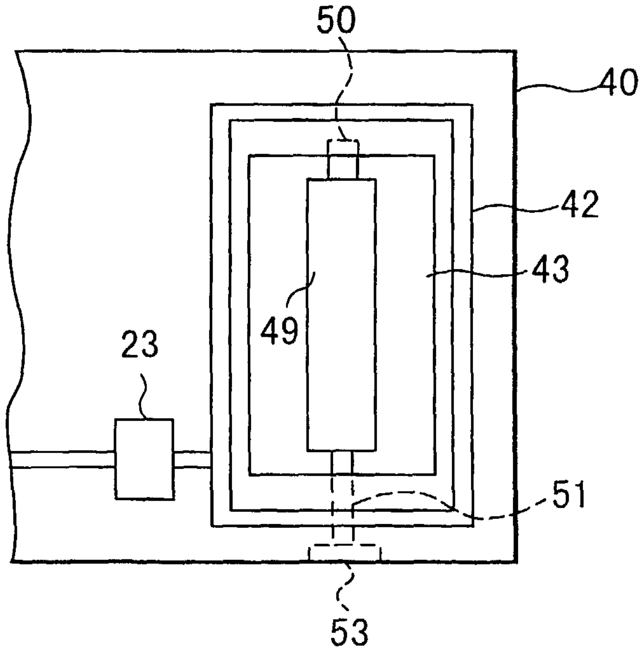


FIG. 21A

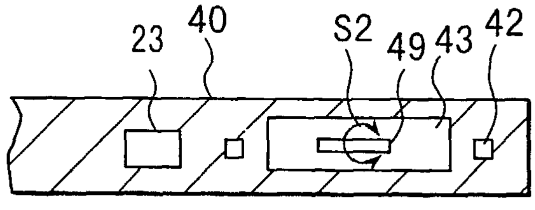


FIG. 21B

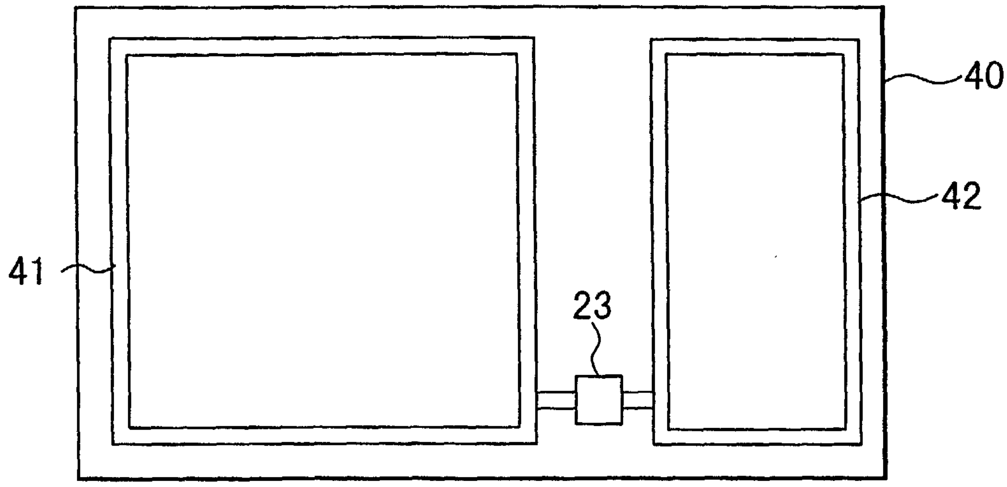


FIG. 22A

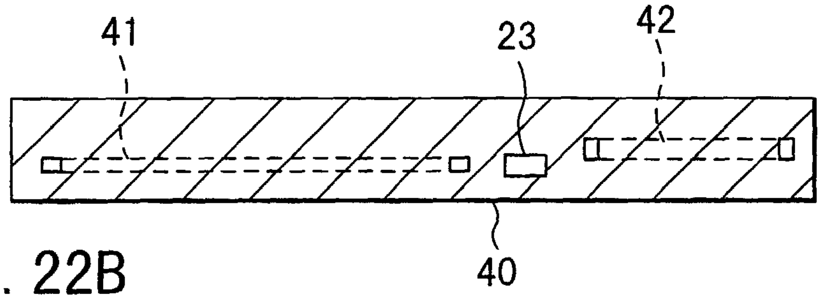


FIG. 22B

FIG. 23

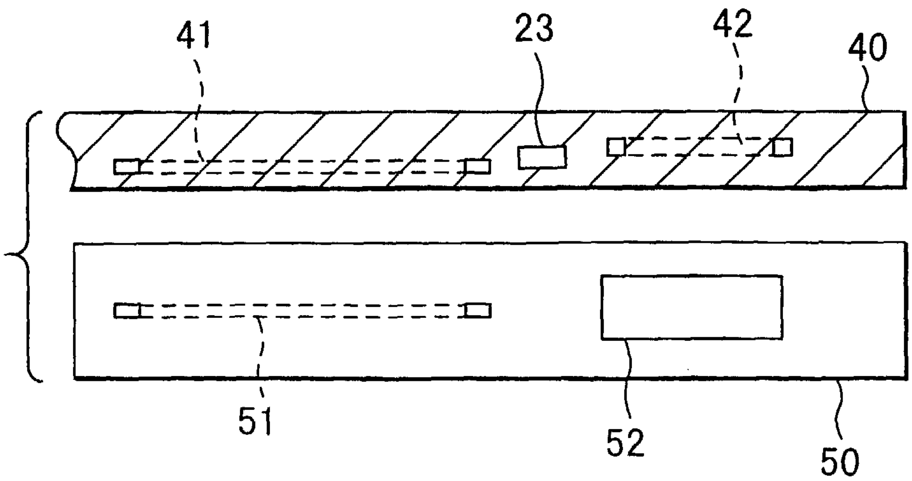

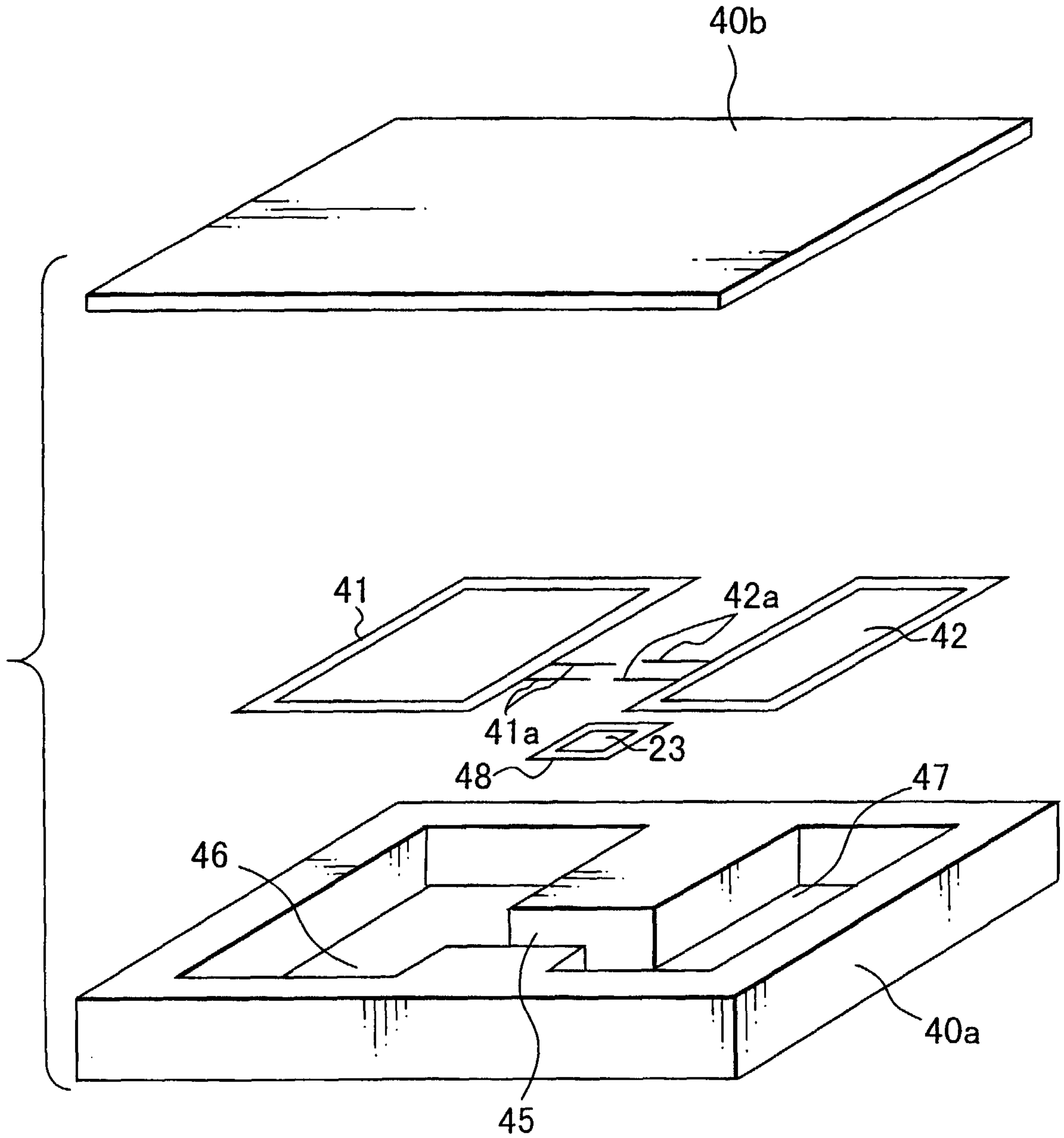


FIG. 24

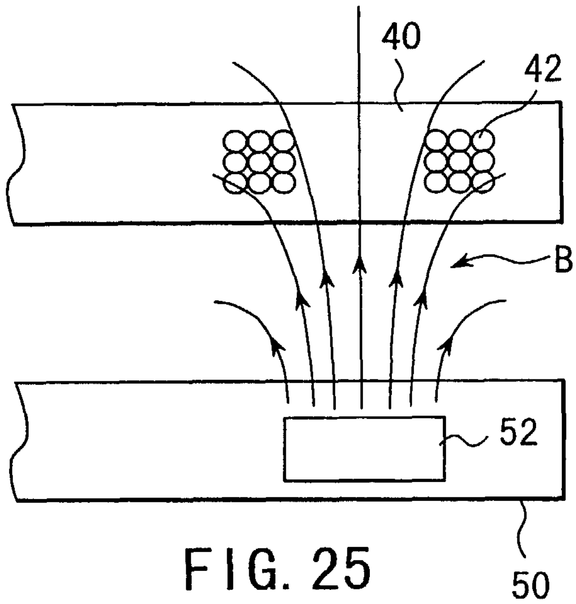


FIG. 25

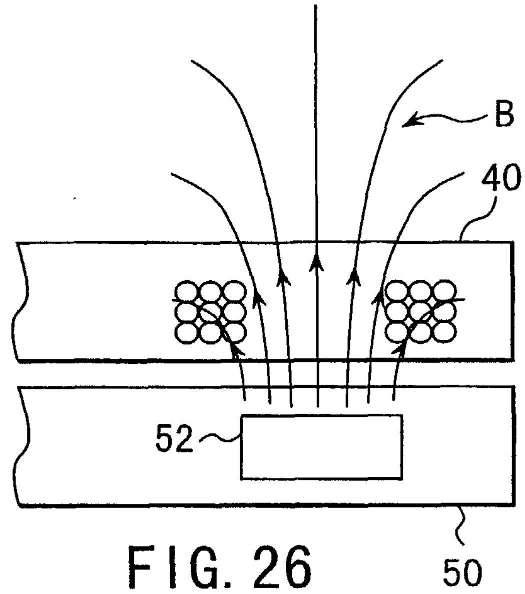


FIG. 26

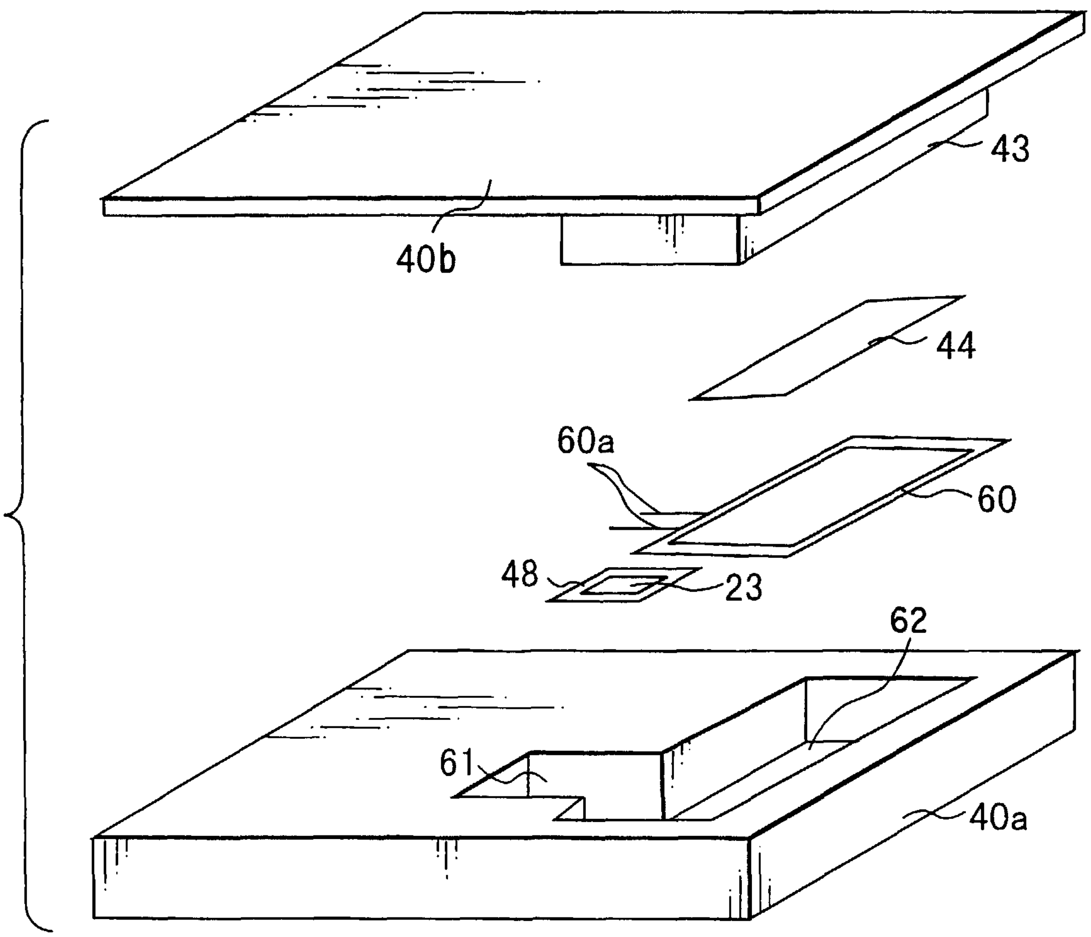


FIG. 27

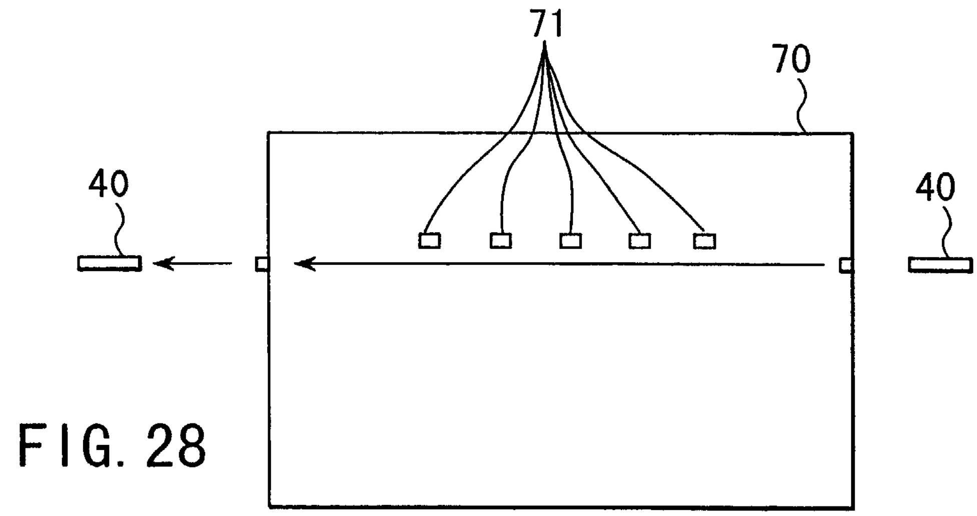


FIG. 28

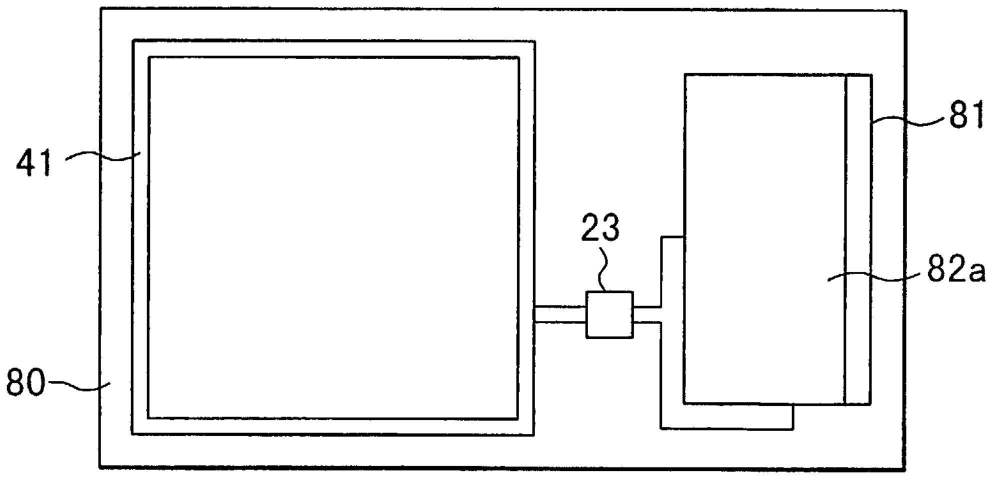


FIG. 29A

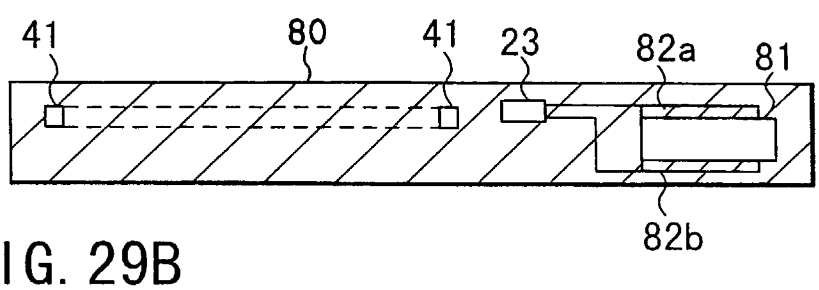


FIG. 29B

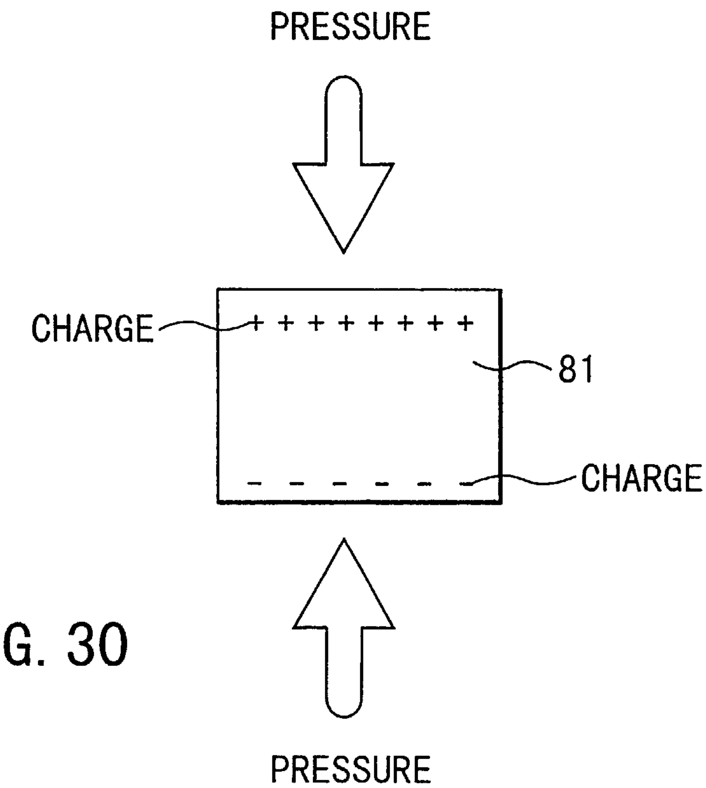


FIG. 30

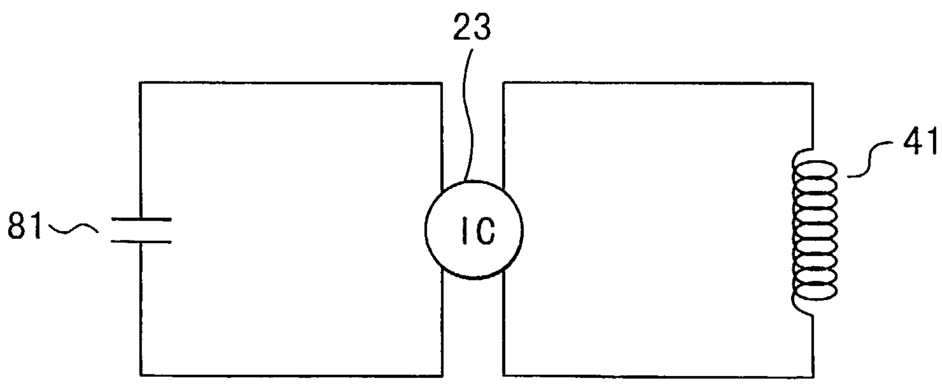


FIG. 31

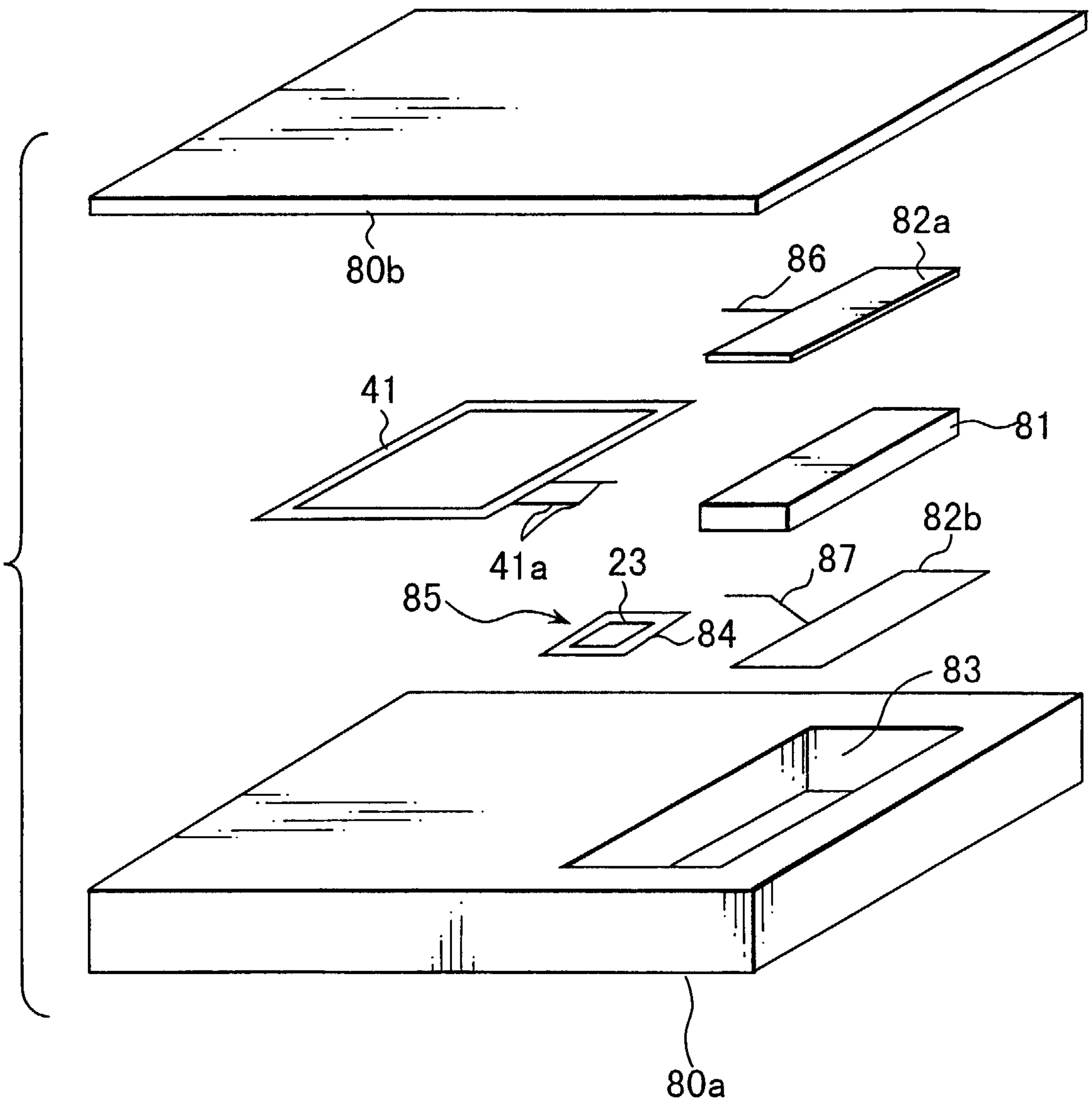


FIG. 32

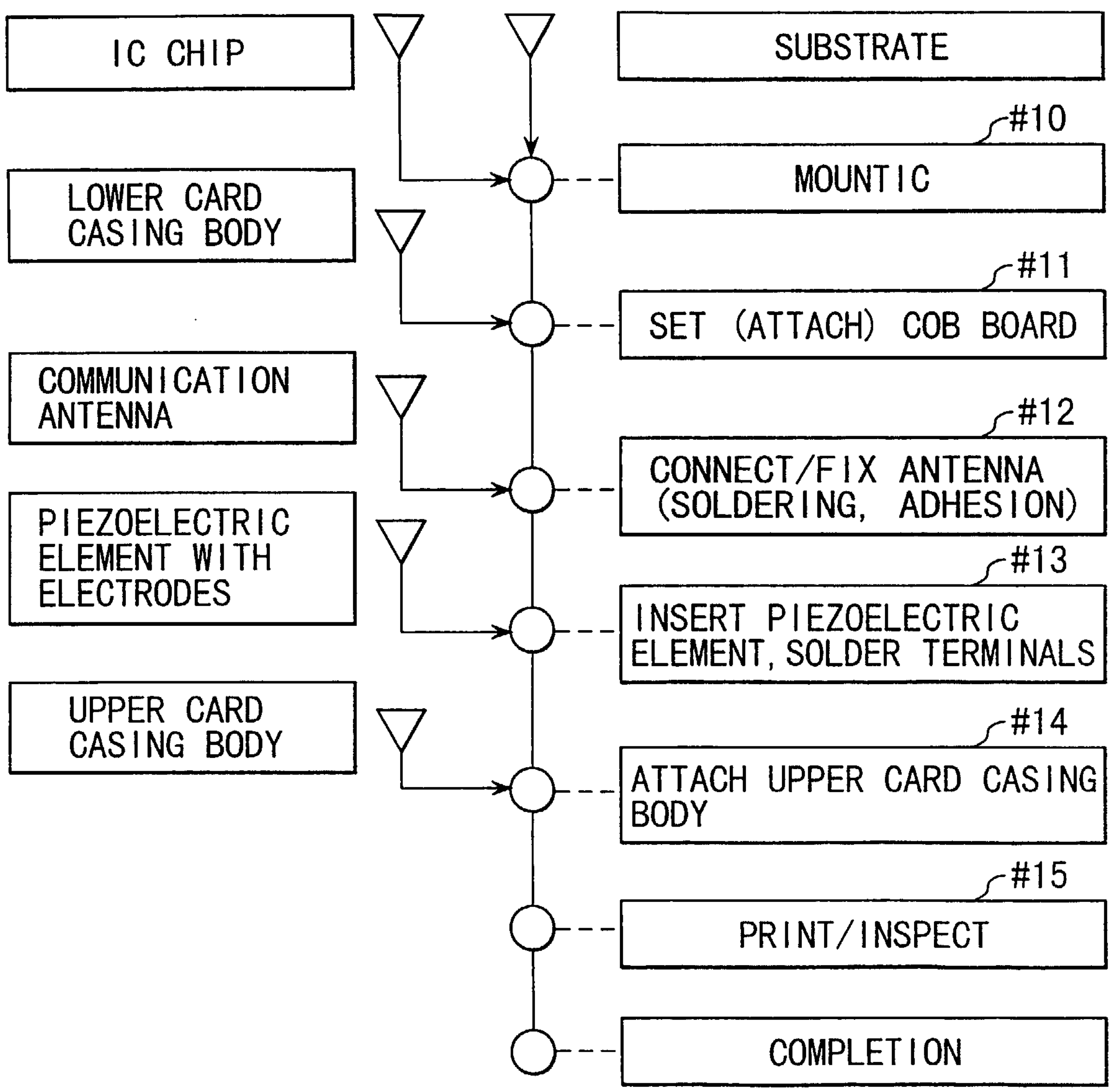
IC CHIP
SUBSTRATE
#10
MOUNT IC
LOWER CARD CASING BODY
#11
SET (ATTACH) COB BOARD
COMMUNICATION ANTENNA
#12
CONNECT/FIX ANTENNA (SOLDERING, ADHESION)
PIEZOELECTRIC ELEMENT WITH ELECTRODES
#13
INSERT PIEZOELECTRIC ELEMENT, SOLDER TERMINALS
UPPER CARD CASING BODY
#14
ATTACH UPPER CARD CASING BODY
#15
PRINT/INSPECT
COMPLETION

FIG. 33

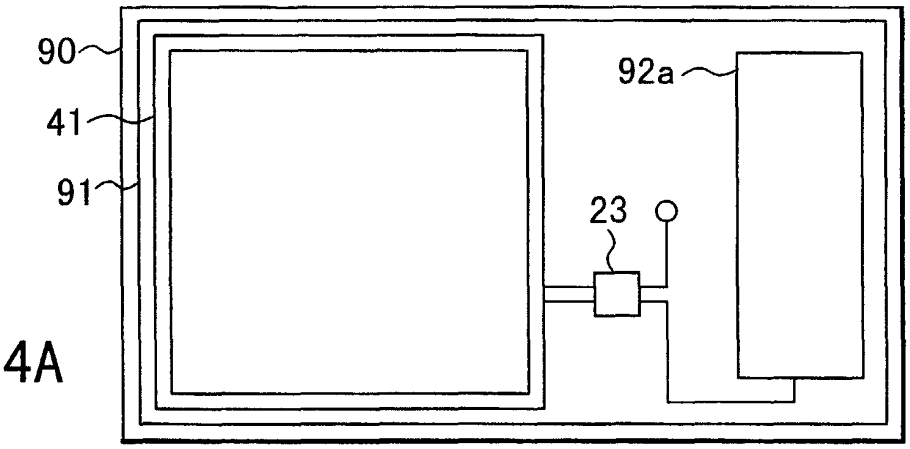


FIG. 34A

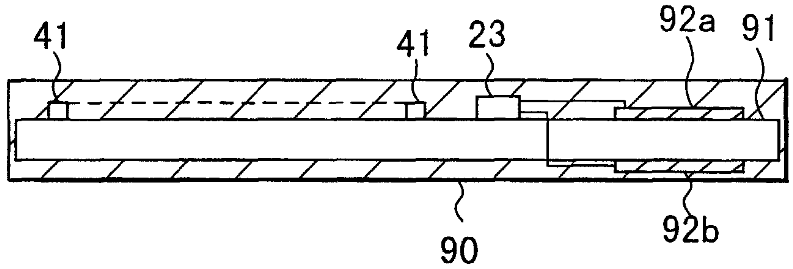


FIG. 34B

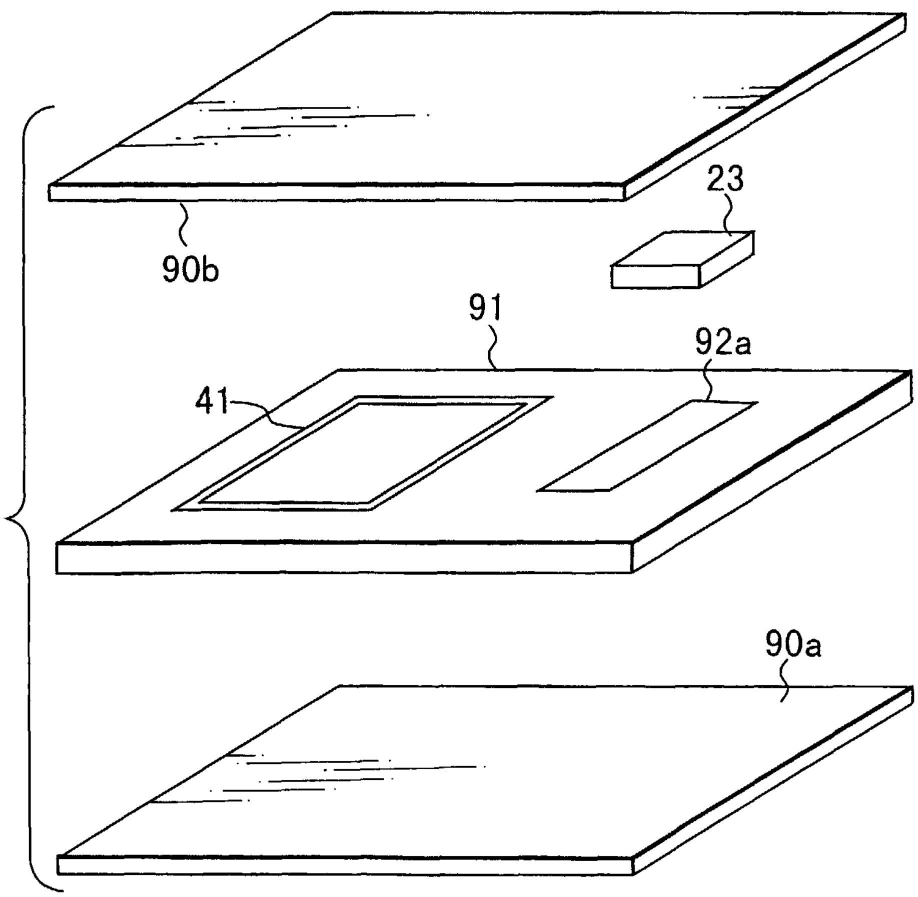


FIG. 35

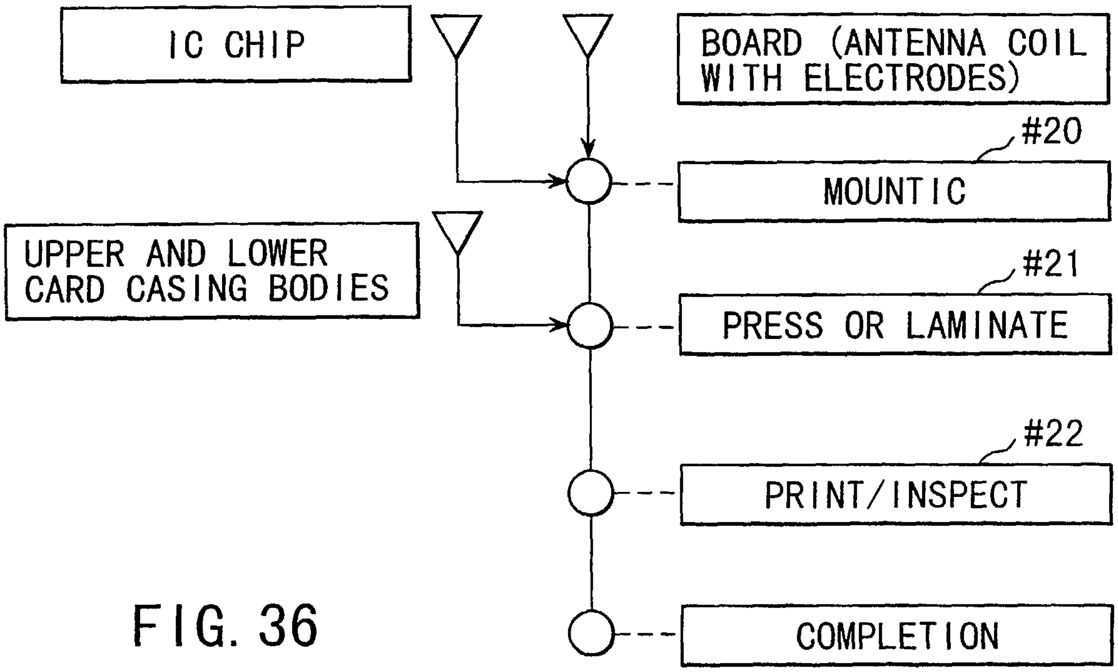


FIG. 36

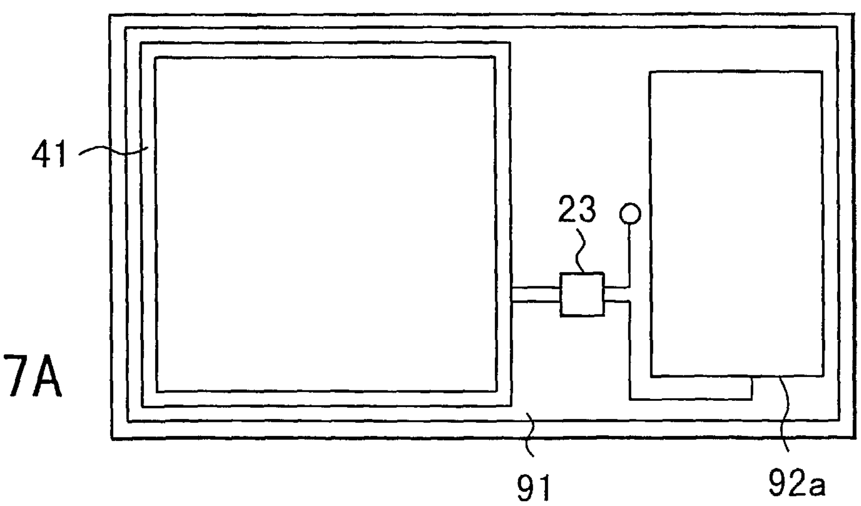


FIG. 37A

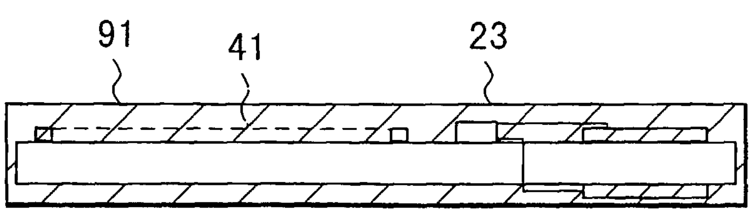


FIG. 37B

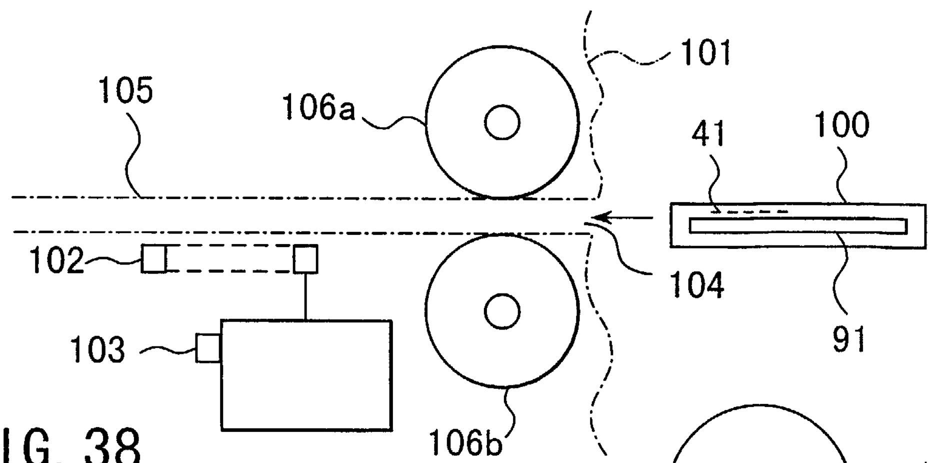


FIG. 38

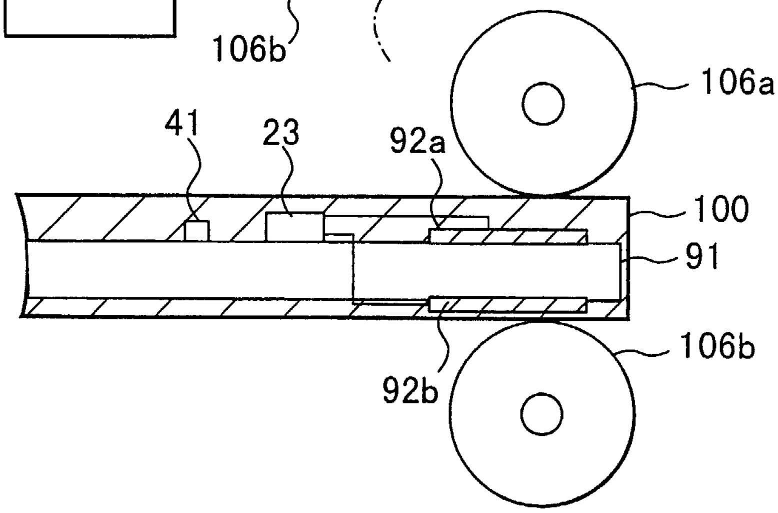


FIG. 39

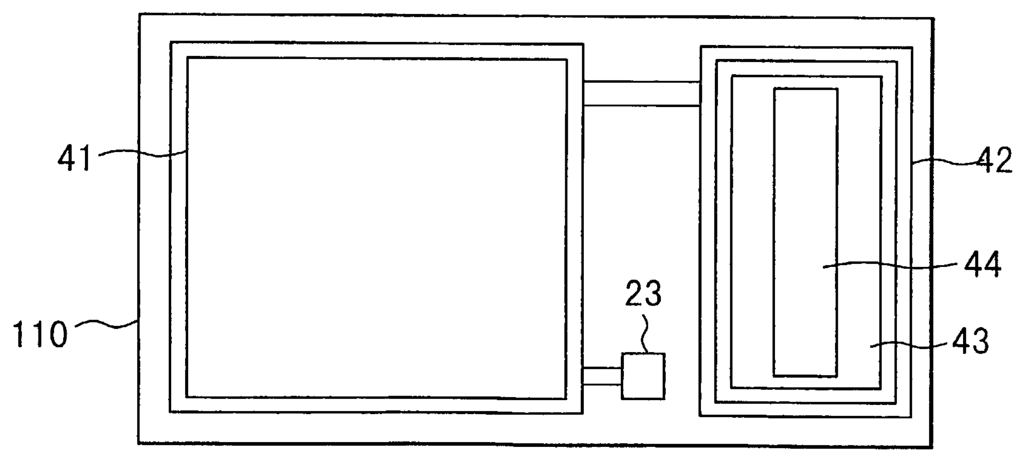


FIG. 40A

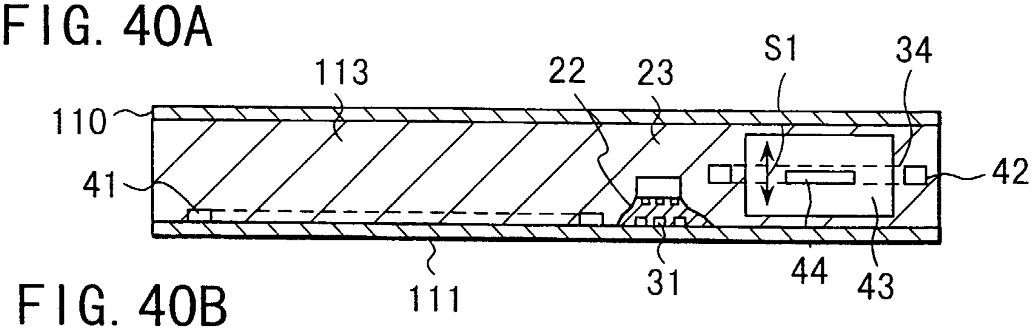


FIG. 40B

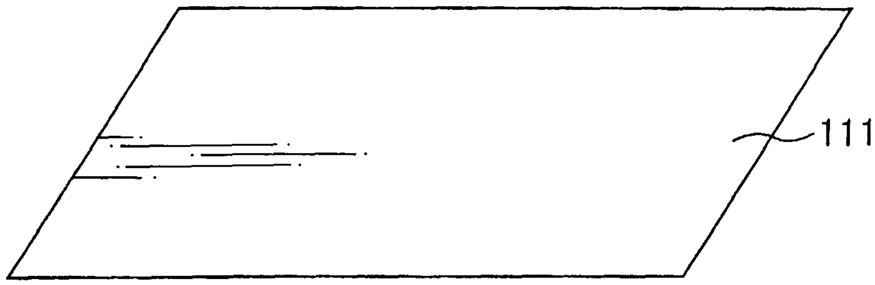


FIG. 41A

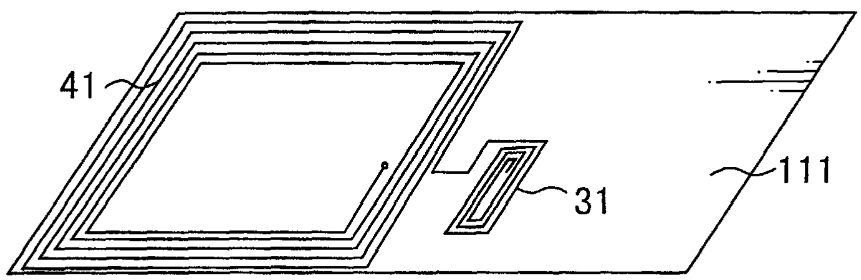


FIG. 41B

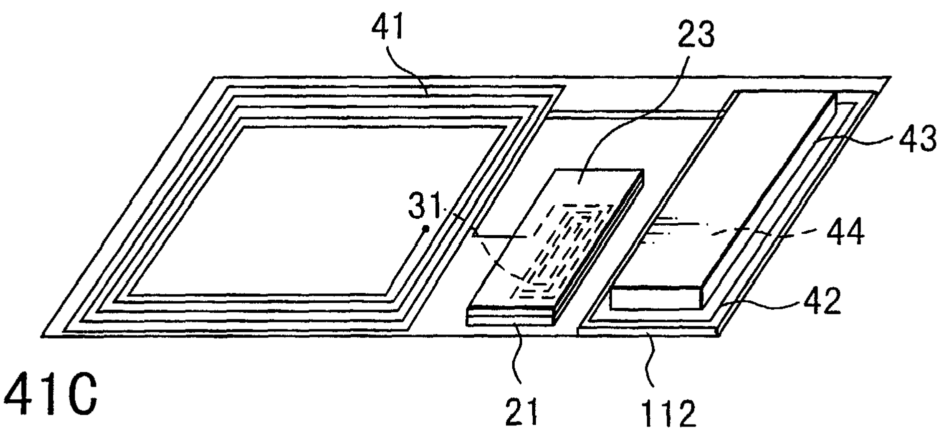


FIG. 41C

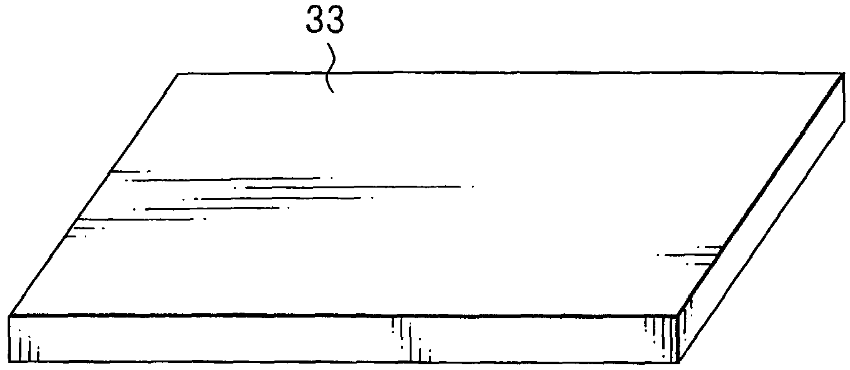


FIG. 41D

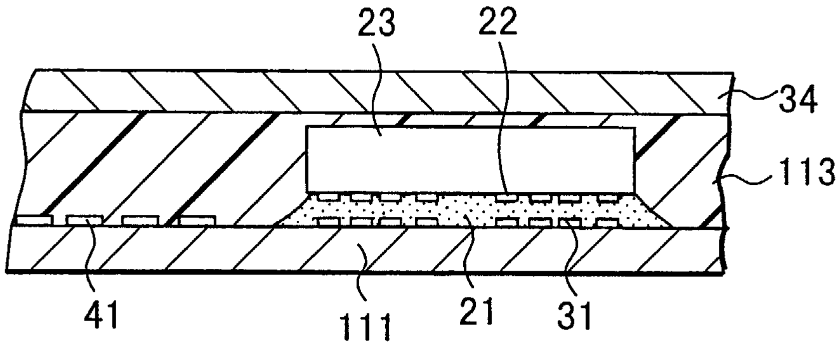
23
22
34
113
41
111
21
31

FIG. 42

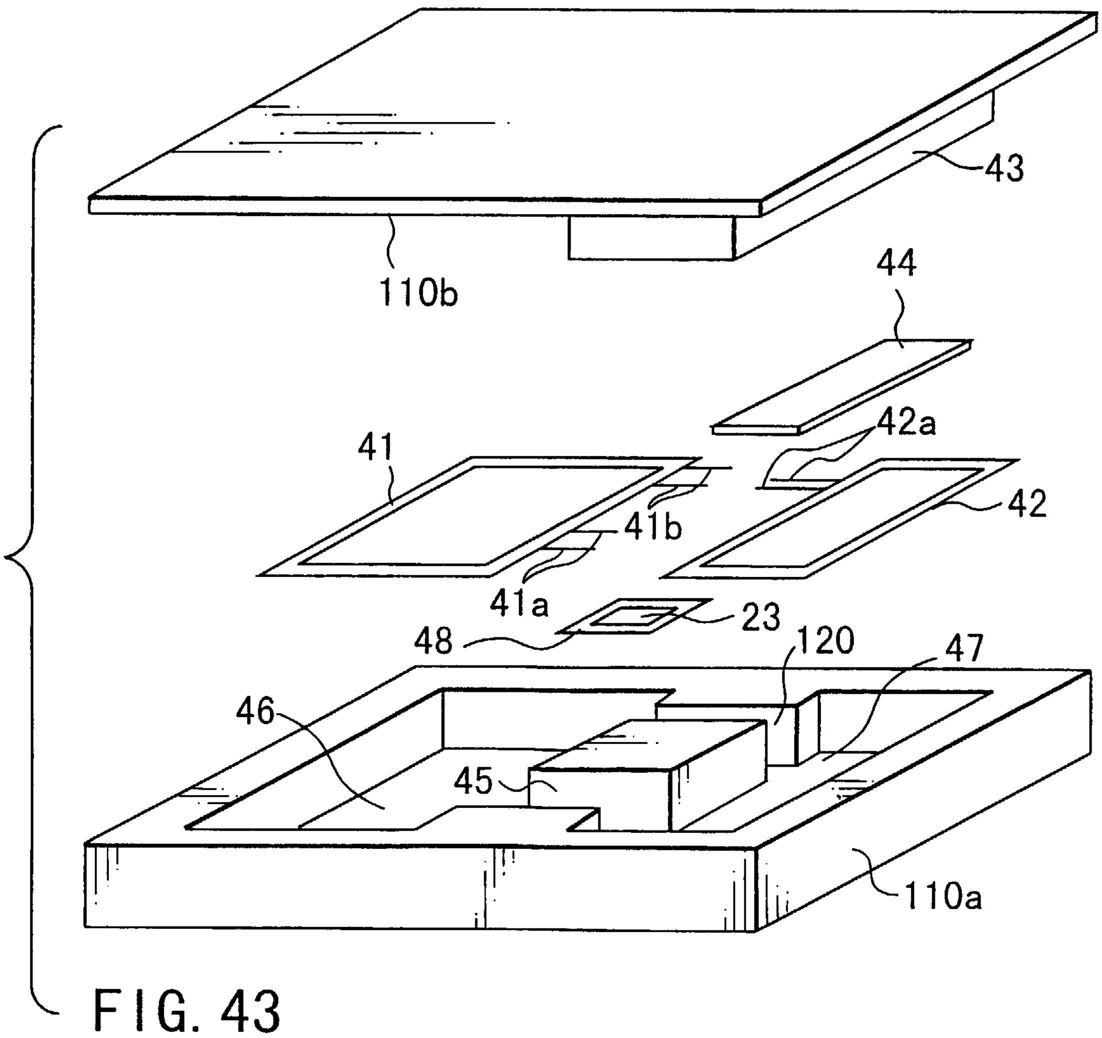
43
110b
44
42a
41
41b
42
41a
23
48
120
47
46
45
110a

FIG. 43

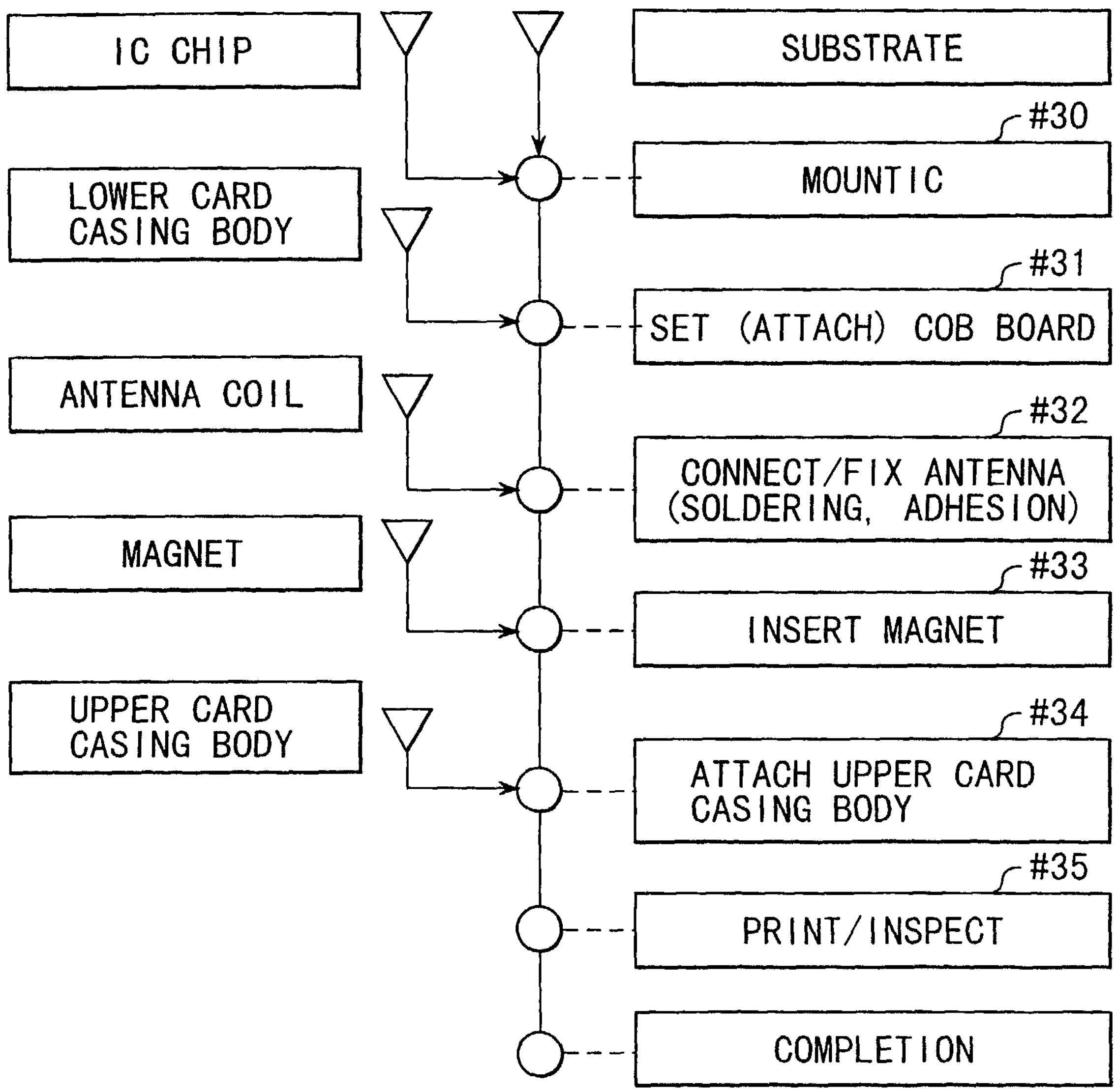
IC CHIP
SUBSTRATE
#30
MOUNTIC
LOWER CARD CASING BODY
#31
SET (ATTACH) COB BOARD
ANTENNA COIL
#32
CONNECT/FIX ANTENNA (SOLDERING, ADHESION)
MAGNET
#33
INSERT MAGNET
UPPER CARD CASING BODY
#34
ATTACH UPPER CARD CASING BODY
#35
PRINT/INSPECT
COMPLETION

FIG. 44